# EUROPEAN PATENT SPECIFICATION

(11) **EP 0 633 823 B1**
(45) Date of publication and mention of the grant of the patent: **02.06.1999**
(21) Application number: 93908539.5
(22) Date of filing: 24.03.1993
(51) Int. Cl.: B23K 26/14, H01L 21/268, B08B 7/00

(54) **REMOVAL OF SURFACE CONTAMINANTS BY IRRADIATION**
ENTFERNUNG VON OBERFLÄCHEN-VERSEUCHUNGEN DURCH AUSSTRAHLUNG
ENLEVEMENT DE CONTAMINANTS DE SURFACE PAR IRRADIATION

(30) Priority: 31.03.1992 US 865039
(43) Date of publication of application: 18.01.1995
(73) Proprietor: CAULDRON LIMITED PARTNERSHIP, Bethesda, MD 20814 (US)
(72) Inventor: ENGELSBERG, Audrey, C., Milton, VT 05468 (US); DEHAIS, Joseph, A. 4545 Connecticut Avenue, N.W., Washington, DC 20008 (US)
(74) Representative: Freylinger, Ernest T.
(86) International application number: US9302734
(87) International publication number: WO9319888

(56) References cited:
- EP-A- 0 233 755
- EP-A- 0 268 301
- EP-A- 0 297 506
- EP-A- 0 380 387
- DE-A- 3 904 969
- JP-A-57 076 846
- JP-A-57 102 229
- JP-A-60 037 736
- JP-A-61 147 988
- JP-A-62 085 433
- US-A- 4 568 632
- US-A- 4 668 304
- US-A- 4 920 994
- US-A- 5 024 968
- US-A- 5 099 557
- US-A- 5 151 135
- PATENT ABSTRACTS OF JAPAN vol. 9, no. 283 (C-313) 9 November 1985 & JP-A-60 129 136 (TOSHIBA KK) 10 July 1985
- PATENT ABSTRACTS OF JAPAN vol. 16, no. 450 (M-1312) 18 September 1992 & JP-A-04 157 088 (FUJITSU LTD) 29 May 1992
- PATENT ABSTRACTS OF JAPAN vol. 12, no. 455 (C-548) (3302) 29 November 1988 & JP-A-63 178 845 (MITSUBISHI HEAVY IND LTD) 22 July 1988

## Description

### Background Of The Invention

This invention relates to an apparatus and a method for removing contaminants from a surface according to the preambles of claims 1, 5 and 29 (see US-A-5 024 968). More particularly, the invention relates to the removal of contaminants from a substrate surface by irradiation that does not alter the molecular crystal structure of the treatment surfaces.

Surface contaminants include discrete pieces of matter that range in size from submicrons to granules visible to the unaided eye. Such contaminants may be fine dust or dirt particles or unwanted molecules comprised of elements such as carbon or oxygen. Contaminants frequently become adhered to a surface by weak covalent bonds, electrostatic forces, van der Waals forces, hydrogen bonding, coulombic forces or dipole-dipole interactions, making removal of the contaminants difficult.

In certain instances, the presence of surface contaminants renders the contaminated substrate less efficient or inoperable for the substrate's designated purpose. For example, in certain precise scientific measurement devices, accuracy is lost when optical lenses or mirrors in the devices become coated with microfine surface contaminants. Similarly in semiconductors, surface defects due to minor molecular contaminants often render semiconductor masks or chips worthless. Reducing the number of molecular surface defects in a quartz semiconductor mask by even a small amount can radically improve semiconductor chip production yields. Similarly, removing molecular surface contaminants, such as carbon or oxygen, from the surface of silicon wafers before circuit layers are deposited on the wafer or between deposition of layers significantly improves the quality of the computer chip produced.

Moreover, a significant portion of the debris that ultimately contaminates silicon wafers during production emanates from production apparatus such as process chambers in which the wafers are placed and pipes that conduct processing gas to the chambers. Accordingly, the level of wafer contamination experienced during the course of production can be significantly reduced by the periodic cleaning of such apparatus.

The need for clean surfaces free of even the finest contaminants has led to the development of a variety of surface cleaning methods. These known methods, however, each have serious drawbacks. For example, wet chemical cleaning eliminates metal ions and soluble impurities, but fails to remove particulate. Conversely, scrubbing techniques eliminate particulate, but employ devices that require regular maintenance and risk damaging the treatment surface due to physical contact. Similarly, pressurized fluid jet cleaning facilitates removal of particulate, but risks damaging treatment surfaces due to the high pressure at which the cleaning fluid is maintained. Further, this technique may electrostatically damage the treatment surface due to the presence of ions in the cleaning fluid. Ultrasonic cleaning is a technique that may also result in physical damage to the treatment surface due to the intensity of sound waves being conveyed in the liquid medium. Additionally, "Megasonics," a high pressure chemical delivery system, may contaminate treatment surfaces with the contents of the very chemical solutions intended to remove contaminant. Similarly, strippable polymer tape may also contaminate treatment surfaces by depositing a polymer residue thereon. Finally, like "Megasonics" and polymer tape, each of the foregoing cleaning techniques employ cleaning tools and/or agents that can introduce as many new contaminants to a treatment surface as they remove.

Another known method for cleaning substrate surfaces without outside agents requires that the treatment surface be melted to release contaminants which are then removed by ultra high vacuum. This method has the disadvantage that the surface being treated must be briefly melted. Such melting may he undesirable, as for example when a semiconductor surface is cleaned between deposition of circuit layers and it is desired that the integrity of the previously deposited layers not be disturbed. Further, such an operation would be difficult if not impossible to implement for cleaning expansive, irregular surfaces, such as those found in pipes and wafer processing chambers. Finally, the ultra high vacuum equipment used in this process is both expensive and time consuming to operate.

Annealing treatment methods suffer similar drawbacks. When a surface is cleaned by annealing methods, the treatment surface of the substrate being cleaned is heated to a temperature that is generally below the melting point of the material being treated but high enough to enable rearrangement of the material's molecular crystal structure. The surface being treated is held at this elevated temperature for an extended period during which time the surface molecular crystal structure is rearranged and contaminants are removed by ultra high vacuum. Annealing cleaning methods cannot be used where it is desired to maintain the molecular crystal structure of the substrate surfaces.

Another currently utilized cleaning method, known as ablation, suffers from its own particular drawbacks. With ablation, a surface or contaminants on a surface are heated to the point of vaporization. Depending on the material being ablated, the material may melt before being vaporized or the material may sublimate directly on heating. With ablation cleaning techniques, if damage to the treatment surface is to be prevented, the ablation energy must be applied accurately to the contaminants only, rather than the surface on which the contaminants lie, a difficult task when the contaminants are extremely small or randomly spaced, or when the surface being treated is irregularly shaped. Even where the ablation energy can be successfully applied only to the contaminant, it is difficult to vaporize the contaminant without also damaging the underlying treatment surface.

Surface cleaning by melting, annealing and ablation can be conducted with a laser energy source. However, using a laser energy source to remove contaminants from a surface by melting, annealing or ablation does not overcome the inherent disadvantages of these processes. For example, in U.S. Pat. No. 4,292,093, "Method Using Laser Irradiation For the Production of Atomically Clean Crystalline Silicon and Germanium Surfaces" the laser annealing method disclosed requires both vacuum conditions and energy levels sufficient to cause rearrangement and melting of the treatment surface. Other known laser surface cleaning methods involving melting or annealing require similar high energy lasing and/or vacuum conditions, as disclosed in U.S. Pat. Nos. 4,181,538 and 4,680,616. Similarly the laser ablation technique disclosed in U.S. Pat. No. 3,464,534, "Laser Eraser" suffers the same drawbacks as other high energy ablation methods.

JP-A-63178845 describes an apparatus for burning off smudge deposits on objects such as optical parts. The apparatus includes a YAG laser light oscillator, a laser catheter, and a blower of heated air.

US-A-5 024 968 discloses a method of removing surface contaminants from the surface of a substrate without altering the molecular crystal structure or otherwise damaging the surface being treated. Gas is flowed across the substrate treatment surface and the substrate is continuously irradiated at an energy density and duration great enough to release surface contaminants from the substrate treatment surface and small enough not to alter the molecular crystal structure of the substrate treatment surface. The irradiation source may be any means known in the art such as a pulsed or continuous wave laser or high-energy lamp. Preferably the radiation is generated by a pulsed ultraviolet laser. The known method is beneficially applied for removing surface contaminants from a generally planar semiconductor substrate before, between and after deposition of the circuitry layers on the semiconductor substrate.

### Summary Of The Invention

According to the present invention, as defined in claims 1, 5 and 29, it is possible to remove contaminants from irregularly shaped surfaces or, more specifically, surfaces lying in non-coincidently related planes. Such planes encompass all possible relationships between the surfaces of a substrate except those occupying the same space or plane. For example, surfaces that are parallel or angularly related, such as opposing interior walls of a pipe or adjacent walls in a cubical chamber, respectively, occupy non-coincidently related planes.

### Brief Description Of The Drawings

Fig. 1 is a schematic diagram of a contaminant removal method and apparatus according to the prior art.
Fig. 2 is a schematic diagram showing how laser radiation is applied in the prior art to remove contaminant from relatively planar treatment surfaces.
Fig. 3 is a schematic diagram showing how laser radiation is applied in the prior art to remove contaminant from relatively planar treatment surfaces.
Fig. 4 is a schematic diagram showing the use of a mask in combination with radiation and gas to remove contaminant from relatively planar treatment surfaces.
Fig. 5 is a schematic diagram of a contaminant removal apparatus for removing contaminant from irregularly shaped treatment surfaces according to the invention.
Figs. 6 through 11 are schematic end views of apparatuses for conveying gas and radiation to irregularly shaped treatment surfaces according to the principles of the invention.
Figs. 12 and 13 are schematic side views showing how the invention of Fig. 5 may be applied to remove contaminant from the interiors of elongated, enclosed passages.
Fig. 14 is an schematic end view of an apparatus for conveying gas and radiation to irregularly shaped treatment surfaces according to the principles of the invention.
Fig. 15 is a partial plan view of the apparatus illustrated in Fig. 14.
Fig. 16 is a partial plan view of another configuration of an apparatus for conveying gas and radiation to irregularly shaped treatment surfaces according to the principles of the invention.
Figs. 17 and 17a are schematic side views showing application of the invention of Fig. 5 with a flexible, porous centering support structure.
Fig. 18 is a schematic side view showing application of the invention with an optic diffuser.
Figs. 19 and 20 are schematic side views showing how the invention of Fig. 5 may be applied to remove contaminant from process chamber interiors.
Figs. 21 and 22 are schematic side views showing how the invention of Fig. 5 may be applied to remove contaminant from the exteriors of irregularly shaped objects.
Figs. 23 and 24 are schematic side views showing how radiation is applied in another embodiment of the invention to remove contaminant from ducted interiors.
Figs. 25 and 26 are schematic end and side views, respectively, showing how radiation is applied in another embodiment of the invention to remove contaminants from the exteriors of irregularly shaped objects.

### Detailed Description

Reference will now be made in detail to presently preferred embodiments of the invention, examples of which are illustrated in the accompanying drawings. Throughout the drawings, like reference characters are used to designate like elements.

### 1. Treatment Method

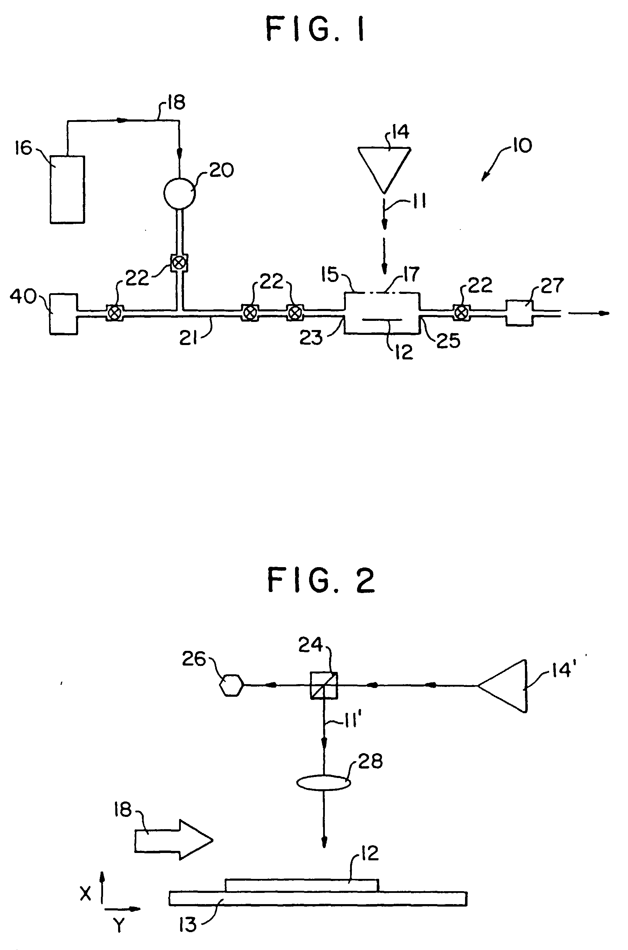

A method and apparatus for removing surface contaminants from the surface of a substrate without altering the molecular crystal structure or otherwise damaging the substrate surface, according to the teaching of US-A-5 024 968, is illustrated schematically in Fig. 1. As shown in Fig. 1, an assembly 10 holds a substrate 12 from which surface contaminants are to be removed. A gas 18 from gas source 16 is constantly flowed over substrate 12. Gas 18 is inert to substrate 12 and is flowed across substrate 12 so as to bathe substrate 12 in a non-reactive gas environment. Preferably, gas 18 is a chemically inert gas such as helium, nitrogen or argon. An enclosure 15 for holding substrate 12 communicates with gas source 16 through a series of tubes 21, valves 22, and a gas flow meter 20.

According to the embodiment shown in Fig. 1, enclosure 15 comprises a stainless steel sample reaction cell fitted with opposing gas inlet and outlet ports 23, 25 respectively. Enclosure 15 is fitted with a sealed optical grade quartz window 17 through which radiation can pass. Inlet and outlet ports 23, 25 may comprise, for example, stainless steel tubing fitted with valves. After sample 12 is placed in enclosure 15, enclosure 15 is repeatedly flushed and backfilled with gas 18 and is kept at a pressure slightly above ambient atmospheric pressure to prevent inflow of other gases. Although enclosure 15 is shown as a solid chamber, it is anticipated that a surface being cleaned could be enclosed in any type of enclosure through which a gas can be flowed. For example, if the surface being treated is a large fixed object, a large portable enclosure such as a plastic bag might be utilized.

Flow of gas 18 may be regulated by flow meter 20 which, in the preferred embodiment, is a Matheson Model 602 flow meter. Valves 22 are preferably metering, regulating or bellows valves suitable for high temperature and pressure applications and for use with toxic, hazardous, corrosive or expansive gases or liquids, as for example "Swagelok SS-4H"™ series valves by Swagelok Co. of Solon, Ohio. Valves 22 can be opened or closed to isolate enclosure 15, to place enclosure 15 in communication with gas source 16 or to place enclosure 15 in communication with another substance, such as a gas for depositing on substrate 12, coming from an alternate source 40.

According to the method, high-energy radiation is irradiated upon the substrate treatment surface at an energy density and duration between that required to release surface contaminants from the substrate treatment surface and that which will alter the molecular crystal structure of the surface. According to the embodiment shown in Fig. 1, a radiation source 14 which may be a laser or high-energy lamp generates radiation 11 directed against the treatment surface of substrate 12. In Fig. 1, source 14 is shown as being outside enclosure 15 and irradiating sample 12 through quartz window 17. However, it is contemplated that source 14 could alternatively be placed within the enclosure 15.

The energy flux and the wavelength of the high-energy irradiation arc preferably selected to be dependent upon the surface contaminants being removed. To this end, a gas analyzer 27 may be connected to outlet port 25. Analyzer 27 analyzes the contents of exhaust gas from enclosure 15 to facilitate selective energy and wavelength adjustment of source 14. Gas analyzer 27 may be a mass spectrometer as, for example, a quadrapole mass spectrometer manufactured by Bruker Instruments, Inc. of Billerica, Massachusetts or by Perkin Elmer of Eden Prairie, Minnesota.

Selection of the source of irradiation used depends upon the desired radiation energy and wavelength. The energy level of the radiation in electron volts/photon (Ev/photon) is preferably at least twice the energy necessary to break the bonds adhering the contaminants to the surface being cleaned. The bond energies between common contaminants (such as carbon and oxygen) and common substrate materials (such as silicon, titanium, germanium, iron, platinum and aluminum) range between 2 and 7 Ev/bond, as disclosed in Handbook of Chemistry and Physics, 68th ed., pp. F-169 to F-177 (CRC Press 1987). Accordingly, radiation sources emitting photons with energies in the range of 4 to 14 Ev/photons are desirable. The wavelength should be below the wavelength that would compromise the integrity of the substrate surface by the well-known photoelectric effect, as described in G.W. Castellan, Physical Chemistry, 2d ed., 458-459 (Academic Press, 1975) which is hereby incorporated by reference. The preferred wavelength depends on the molecular species being removed and the resonance states of such species.

Any means known in the art for generating radiation of a suitable energy level may be used in the invention, including high-energy lamps and lasers. Depending upon the application, it is anticipated that light energy from such sources may range from deep ultraviolet to infrared, with corresponding wavelengths from 193-3000 nm, respectively.

The wavelengths and photon energies of a number of suitable lasers are listed in Table 1, below.

**Table I**

| Laser | Wavelength (nm) | Ev/photon |
|---|---|---|
| XeCl, pulsed | 308 | 4.04 |
| argon-ion, continuous wave | 257 | 4.83 |
| KrF, pulsed | 248 | 5.01 |
| ArF, pulsed | 193 | 6.44 |
| Tunable dye lasers, pulsed or continuous wave | 200-800 | 6.22-1.55 |

These lasers are described in greater detail in the following references: M.J. Webber, ed., CRC Handbook of Laser Science, Vols. 1-5 (1982-1987); Mitsuo Maeda, Laser Dyes (Academic Press 1984); and laser product literature from Lambda Physik at 289 Great Road, Acton, Massachusetts, Coherent, Inc. at 3210 Porter Drive, Palo Alto, California, and Spectra-Physics at 1250 West Middlefield Road, Mountain View, California. It is anticipated that high-energy xenon or mercury lamps or other types of lasers, including visible, ultraviolet, infrared, x-ray or free electron lasers might be utilized as appropriate sources of radiation.

The irradiation directed against the substrate treatment surface from which contaminants are being removed has a power density less than that required to alter the molecular crystal structure of the surface. Preferably, the power density and duration of the irradiation are selected so as to impart an amount of energy on the substrate surface that is significantly below the energy required for alteration of the substrate surface structure. The preferred energy level is dependent on the composition of the substrate being treated. For example, with certain substrate materials such as plastics, this energy level would be much lower than for other materials such as high strength carbide steels. The heats of formation for various materials are well known and are reported in the Handbook of Chemistry and Physics, 68th ed., pp. D33-D42 (CRC Press 1987). The heat of formation generally corresponds to the amount of heat required to break down various materials and can be used as a guideline in selecting an irradiation energy density and duration that will not alter the molecular crystal structure of the treatment surface. The heats of formation of a number of common substrate materials are summarized in Table II, below.

**Table II**

| Material | Heat of Formation |
|---|---|
| Al₂O₃ | 16906.7 kJ/mol; 17.52 Ev/molecule |
| SiO₂ | 840.3 kJ/mol; 9.11 Ev/molecule |
| Nb₂O₅ | 1528.2 kJ/mol; 13.27 Ev/molecule |
| NiO | 230.6 kJ/mol; 2.50 Ev/molecule |
| Ti₂O₃ | 500.2 kJ/mol; 15.63 Ev/molecule |

The irradiation energy density and duration used is such that the heat of formation is not approached on the substrate treatment surface. Finding the maximum energy usable on a given substrate material, however, will require some experimentation in light of the material's known heat of formation. Such experimentation ensures that annealing ablation and melting will not occur.

When a substrate surface is irradiated as described above, the bonds and/or forces holding surface contaminants to the substrate surface are broken and the inert carrier gas carries contaminants away from the substrate surface during irradiation. As long as the cleaned substrate remains in the inert gas environment, new contaminants will not form on the substrate surface. If necessary, a suitable trapping system may be connected to enclosure outlet 25 for trapping and neutralizing removed contaminant species.

### 2. Planar Treatment Surfaces

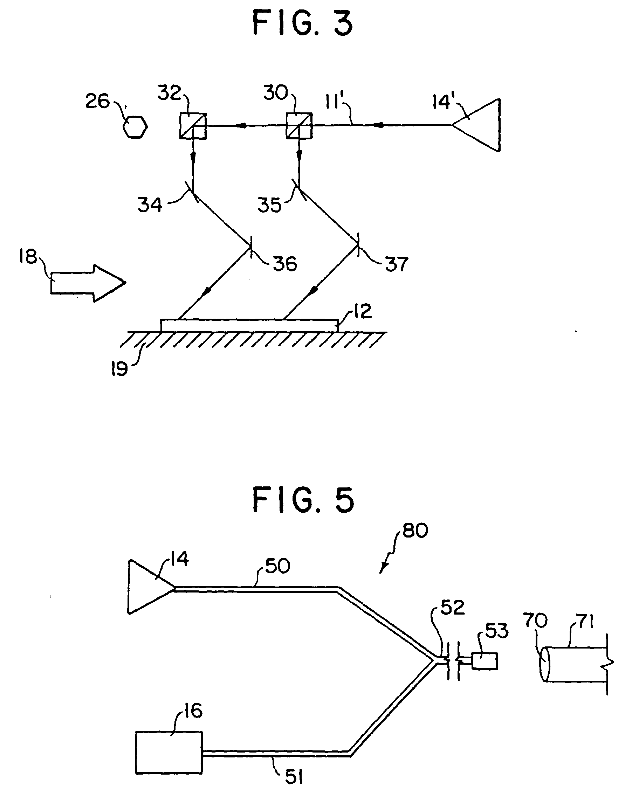

A planar substrate being treated in accordance with the teaching of US-A-5 024 968 may be selectively irradiated with a laser. As shown in Fig. 2, for example, substrate 12 is fixed on an XY table 13, which is selectively moved with respect to a fixed beam of laser pulses 11' that are generated by a laser 14', directed through a beam splitter 24 and a focusing lens 28 before contacting selected portions of the surface of substrate 12 over which inert gas 18 flows. Alternatively, as shown in Fig. 3, laser pulses 11' may be split by beam splitters 30, 32 into two sets of pulses which are selectively moved by adjusting mirrors 34-37 over the surface of substrate 12 on a fixed table 19. A laser power meter 26, measuring energy directly from the laser, allows for close monitoring of the laser power being applied to the substrate. Suitable laser power meters are available from Digirad of Oriskany, New York and Scientech, Inc. of Boulder, Colorado.

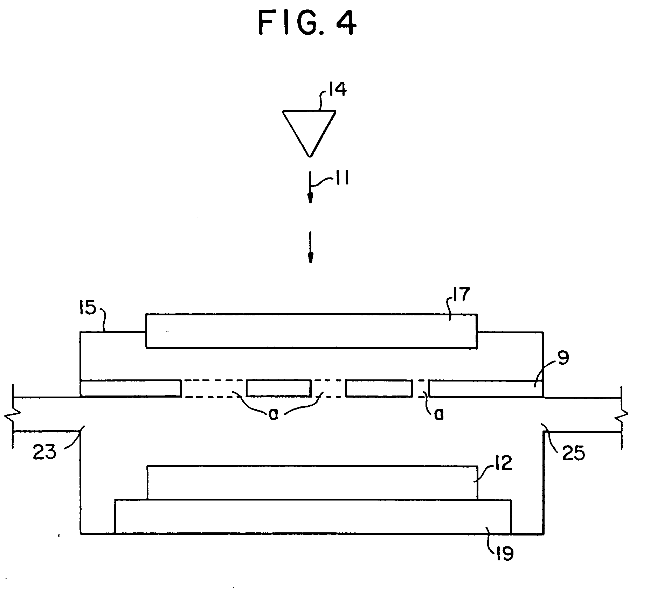

Furthermore, selective irradiation of a planar surface may be achieved through the use of a mask, similar to that used in the semiconductor industry, placed between the source of radiation and the treated substrate. As shown in Fig. 4, mask 9 facilitates selective irradiation of substrate 12 secured to fixed table 19 by limiting access of radiation 11 to substrate 12 through mask passages a. As detailed in Fig. 1, enclosure 15 comprises a stainless steel sample reaction cell fitted with opposing gas inlet and outlet ports 23, 25, respectively, and sealed optical grade quartz window 17 through which radiation can pass.

It is anticipated that high-energy lamps may also be used to irradiate planar surfaces in configurations similar to that disclosed in Figs. 2 through 4.

The following examples illustrate application of the method on generally planar treatment surfaces. In Example I, various energy densities of a pulsed KrF excimer laser are applied to a silicon oxide substrate with varying degrees of success. In Example 11, the application of the method in the area of optical components is examined.

### Example I

The native oxide of silicon is necessary for the promotion of thin film growth on semiconductor surfaces. Unfortunately, when semiconductor surfaces of silicon oxide are exposed to the environment, carbon contaminants adhere weakly to the semiconductor surface. The presence of these contaminants greatly reduces the conductivity or the insulating nature of the thin film to be deposited. Therefore, in semiconductor production, great precautions are taken to minimize environmental exposure through the use of elaborate vacuum, chemical and mechanical techniques. Vacuum techniques are expensive especially if high or near ultra high vacuum is used to keep surfaces clean between processing steps. Chemical (wet and dry) and mechanical techniques can damage the substrate treatment surface and, if the substrate being treated is a processed integrated circuit, the underlying structure.

In an attempt to overcome these problems, radiation from a pulsed KrF excimer laser whose fundamental wavelength is 248 nm (UV range) was applied to the surface of a silicon substrate in a sealed box through which argon gas was flowed. To decrease surface carbon contamination and decrease carbon percentage associated with chemisorbed organometallic (trimethyl aluminum), a precursor to aluminum thin film formation in semiconductor production, irradiation of 35 mj/cm² for 6000 laser shots at a 10 Hz repetition rate was applied to a silicon oxide substrate surface with the KrF excimer laser. The laser treated surfaces were exposed during a continuous flow of argon gas at a flow rate of 16 1/hr under a 1.37x10⁵ Pa (1.03 x 10³ torr) backing regulator pressure. After treatment, X-ray Photoelectron Spectroscopy ("XPS") analysis showed the substrate exhibited a significant decrease in surface carbon from a pretreatment average surface carbon covering 30-45% of the substrate surface to an after treatment average surface carbon covering 19% of the substrate surface. The substrate surface itself showed no damage or alteration.

A surface treated by a laser irradiation as described above and then exposed to an organometallic gas flow showed, by XPS analysis, that 20.8% of the substrate surface was covered with carbon as compared to 40-45% of the substrate surface that was covered with carbon after organometallic gas exposure on a non-laser treated surface. When the laser was applied, as described above, both prior to exposure to organometallic gas and again after gas exposure, only 8.9% of the surface was covered with carbon. Areas adjacent to the laser-exposed areas also exhibited some effects of the laser-cleaning treatment. Areas adjacent to the treated area showed a reduced carbon level of 12.7 percent. This effect probably is due to the gaussian nature of the applied laser pulse.

Transfer of the wafer from the sample cell to the XPS analyzer was via an argon filled glove box. The silicon wafer was transferred to the XPS through an inert UHV transfer rod. This kept environmental exposure to a minimum.

Another wafer of silicon oxide, while exposed to argon gas as described above, was exposed to pulsed KrF excimer laser irradiation of 9 mj/cm² for 6000 shots at a 10 Hz repetition rate. XPS analysis showed a surface carbon coverage of 40-45% both before and after laser treatment. Thus, irradiation at 9 mj/cm² did not remove adsorbed surface carbon.

Another wafer or silicon oxide, while exposed to argon gas as described above, was exposed to pulsed KrF excimer laser irradiation of 300 mj/cm² for 6000 shots at a 10 Hz repetition rate. At the end of treatment, the substrate surface had suffered significant damage, including a hole through the substrate. Thus, irradiation at 300 mj/cm² altered the molecular crystal structure of the substrate surface.

These examples show laser irradiation at an appropriate energy flux and wavelength can decrease surface contamination without damaging underlying surface or adjacent structures.

It is expected, in view of the heat of formation of SiO₂, that subjecting a silicon oxide substrate surface to pulsed KrF excimer laser irradiation of less than 100 mj/cm² for 6000 shots at a 10 Hz repetition rate would not alter the molecular crystal structure of the substrate. Pulsed KrF excimer laser irradiation of less than 75 mj/cm² for 6000 shots at a 10 Hz repetition rate is not expected to alter a silicon oxide substrate surface in any way.

### Example II

High energy optical components are difficult to fabricate for such technologies as laser fusion, x-ray lithography and UV excimer laser optics. Laser fusion and x-ray lithography technologies are used exclusively in "clean" environments. Excimer laser optics have a short work life span because with current commercial film deposition technology, it is difficult to fabricate films capable of withstanding prolonged high-energy fluxes.

A perennial problem with high energy optics is optical breakdown. This phenomena can be described as "the catastrophic evolution of damage inflicted in a transparent medium in a strong laser field." Y.R. Shen, Principles of Nonlinear Optics, 1st ed., 528-540 (Wiley Interscience 1984). This phenomena occurs in solids as well as gases. With a solid, such as a high energy optic, optical breakdown is exacerbated by the presence of a surface defect such as scratches and pores in the bulk material. In most cases, optical breakdown is due to surface contamination such as adsorbed dust particles. The presence of these contaminants lowers the breakdown threshold which in turn limits the maximum laser power that can be used from a given laser system. This fact is a very important limitation regarding the pumping of a laser medium (solid state or gaseous) by an external pump energy source. This, in turn, limits the laser power that can be used to transmit energy through optical windows, lenses and other optical components.

Optical breakdown, for example on a solid, is promoted by the presence of surface adhered contaminants. The interaction of a laser pulse train with a sufficient energy cross section may deposit enough energy to generate an "avalanche" ionization on the solid surface. This can form a surface plasma which may disintegrate the solid. The presence of contaminants effectively decreases the laser's efficiency and decreases its use in potential applications.

To overcome the above described problems, the contaminant removal method, as described herein, can be used to remove adhered contaminants such as adsorbed dust. For example, to treat an optical component, the component is exposed to a continuous flow of argon gas during which time a pulse KrF excimer laser is directed at the surface of the optical component. The laser is tuned to an appropriate energy flux and wavelength that is considerably less than the high energy pulse required to promote ionization and subsequent plasma in high energy optics. The optical component surface is irradiated at the selected flux and wavelength for a duration sufficient to remove adsorbed contaminants.

### 2. Irregularly Shaped Treatment Surfaces

The embodiments disclosed in Figs. 2 through 4 are directed primarily towards the treatment of planar or flat substrates, such as silicon wafers. Accordingly, their application is restricted to those substrate surfaces that may be conveniently secured within a process chamber and configured to permit adequate exposure to a source of radiation emanating from a generally fixed location.

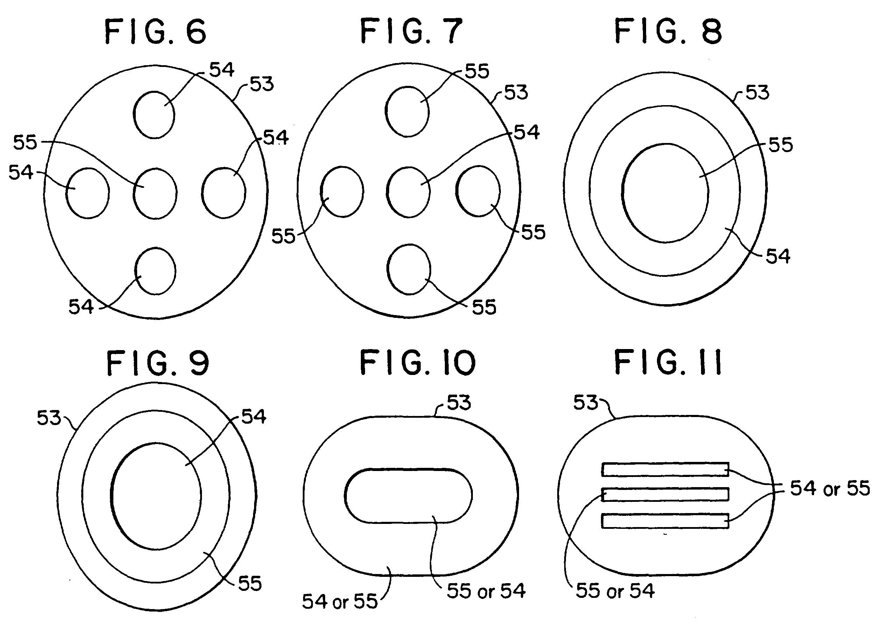

Figs. 5 through 26 disclose embodiments of the present invention capable of removing surface contaminants from objects having irregularly shaped internal and external substrate surfaces or, more specifically, surfaces that lie in non-coincidently related planes. Such planes encompass all possible relationships between the surfaces of a substrate except those occupying the same space or plane. For example, surfaces that are parallel or angularly related, such as opposing interior walls of a pipe or adjacent walls in a cubical chamber, respectively, occupy non-coincidently related planes.

Significantly, the apparatuses disclosed in Figs. 2 through 4 are incapable of treating such substrate surfaces. These apparatuses are strictly limited to singularly planar substrates. Conversely, the apparatuses in Figs. 5 through 26 may effectively treat surfaces occupying non-coincidently related planes either sequentially or simultaneously, as discussed more fully below,

Although not shown in these figures, a gas analyzer 27, such as that described above, and/or particle detector may be incorporated into these embodiments to facilitate selective energy and wavelength adjustment of source 14 as described above. Suitable particle detectors may be obtained from Particle Measuring Systems, Inc. of Boulder, Colorado and Tencor Instruments of Mountainview, California.

Fig. 5 schematically illustrates an apparatus 80 for removing contaminants from elongated enclosed passages, such as pipes 71. Radiation from a radiation source 14 is conducted through a radiation conduit 50, which is an optical waveguide such as a bundle of optical fibers or light pipe, while a gas inert to the substrate treatment surface is conducted from gas source 16 to the treatment surface via gas line 51. Radiation conduit 50 and gas line 51 merge at or before cable head 53, where they may be "bundled" into a single cable 52. Cable head 53, connected to the end of cable 52, includes radiation passages 54 (which may be one or more optical fibers) and gas passages 55. Various configurations of cable head 53 are illustrated in cross section in Figs. 6-11.

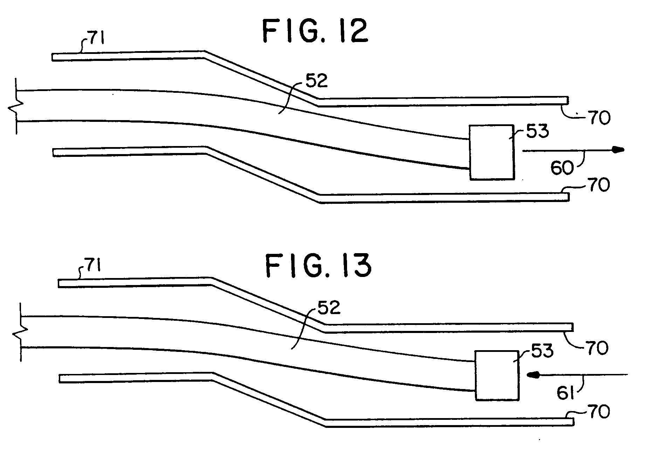

The geometric shape and configuration of radiation passages 54 and gas passages 55 at the end of cable head 53 may be selected based upon the intensity and distribution of radiation and/or gas turbulence required for a particular application (i.e., elongated enclosed passages or more expansive, planar surfaces). For example, Figs. 6 and 7 disclose configurations that are biased toward enhanced radiation exposure and gas turbulence, respectively. Further, Figs. 6-9 provide geometries that convey an uneven amount of gas and/or radiation as they repeatedly pass normally over a surface. These are contrasted with the even distribution of gas and radiation provided by Figs. 10 and 11 when directed normally to a surface. Alternatively, Figs. 8 and 9 provide a relatively uniform distribution of gas and radiation when applied to surfaces generally parallel to the axis of cable head 53, as discussed more specifically below. Although gas and radiation control is enhanced through the use of cable head 53, it is anticipated that in certain applications this element may be eliminated altogether, allowing gas and radiation to simply emanate directly from the ends of gas conduit 51 and radiation conduit 50.

In addition to facilitating multiple radiation passages 54 and gas passages 55, cable head 53 provides means for redirecting the radiation and gas to substrate treatment surface 70. Such redirection is necessary when apparatus 80 is used for cleaning the interiors of narrow passages such as pipes 71, as shown in Figs. 12 and 13, where the axis of cable head 53 must be generally parallel to the treatment surface 70.

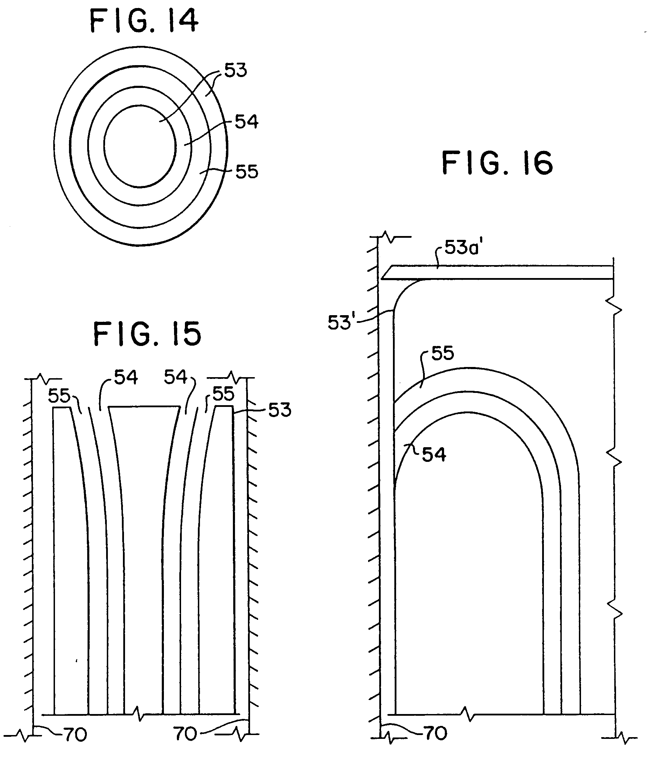

As shown in Fig. 15, radiation passage 54 and gas passage 55 flare outwardly from the centerline of cable head 53, thereby directing both the radiation and gas flow toward the inner walls of the passage to be cleaned. The angle of the flare from the centerline of cable head 53 may range from only a few degrees to more than 90° as shown in Figs. 15 and 16, respectively. The configuration of cable head 53 is application-specific, related to gas flow rate and photon delivery requirements for contaminant removal. More specifically, cable head 53 directs radiation at the appropriate density and angle of incidence for a particular contaminant and substrate while maintaining a continuous flow of inert gas across that portion of the substrate being irradiated.

In operation, apparatus 80, and more specifically cable 52 and cable head 53, may traverse an elongated, enclosed passage 71 in either a forward or reverse direction, as shown in Figs. 12 and 13, respectively. When moving forward, as denoted by arrow 60 in Fig. 12, cable head 53 may be configured as shown in Fig. 15. Radiation passage 54 and gas passage 55 may be disposed in the inner and outer passages, respectively, of cable head 53. In this way, the irradiation of substrate surface 70 from energy conveyed through radiation passage 54 will occur downstream from the flow of gas emanating from the discharge end of gas passage 55, and any dislodged contaminants will be continually pushed ahead of cable head 53 by discharged gas as the cable head moves forward.

Alternatively, cable head 53 may move in a reverse or backward direction denoted by arrow 61 of Fig. 13. When moving backwardly, cable bead 53' may be configured as shown in Fig. 16. Radiation passage 54 and gas passage 55 may be disposed in the outer and inner passages, respectively, of cable head 53'. Gas discharged from gas passage 55 flows back along cable 52 in the annular space between the cable and pipe 71. In this way, the portion of substrate surface 70 being irradiated by energy conducted through radiation passage 54 will be blanketed by the gas, and any dislodged contaminants will be continually pushed by gas in the direction of movement of cable head 53' as the cable head moves backwardly along the pipe. To prevent contaminant-laden gas from passing into the portion of the pipe already treated, a cap may be placed at the end of the pipe nearest the portion first treated. Alternatively, a cap 53a', as illustrated in Fig. 16, may be mounted on the end of the cable head 53'. This cap has an outside diameter slightly less than the inside diameter of pipe 71, so that the annular flow area between the cap and the pipe is much less than the annular flow area between pipe 71 and cable 52 or cable head 53'. The gas will therefore flow away from cap 53a' and toward cable 52.

In both forward and backward moving configurations, the constant flow rate of the inert gas discharged from gas passage 55 is sufficient to move the contaminants away from the area of treatment. This flow of gas may also serve as a means for centering cable head 53 within elongated enclosed passages to be cleaned. As shown in Figs. 14-16, gas passage 55 may be configured as an annular ring directed outwardly from the centerline of cable 52. Should sufficient gas pressure be applied, the uniform, outwardly directed gas from gas passage 55 may center cable head 53 within an elongated, enclosed passage.

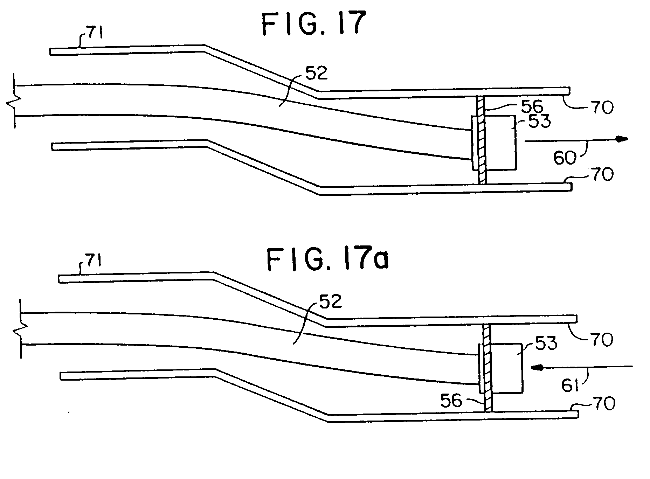

Alternatively, flexible, porous support structure 56, composed of a stable and non-particle shedding material, may be placed around cable head 53 for centering purposes, as shown in Figs. 17 and 17a. To avoid contaminating cleaned surfaces, support structure 56 should never contact treated surfaces, whether cable head 53 moves in a forward (arrow 60) or reverse (arrow 61) direction. Thus, support structure 56 should pass over the substrate surface ahead of the radiation treatment. In such an application, the structure must be sufficiently porous to allow gas and dislodged contaminant to flow through it as cable head 53 traverses the enclosed passage. In the forward moving embodiment shown in Fig. 17, gas passages 55 and radiation passages 54 (not shown) may exit from the side of cable head 53 rather than from its face as illustrated in Figs. 14 and 15 to enable installation of support structure 56 downstream of gas and contaminant flow.

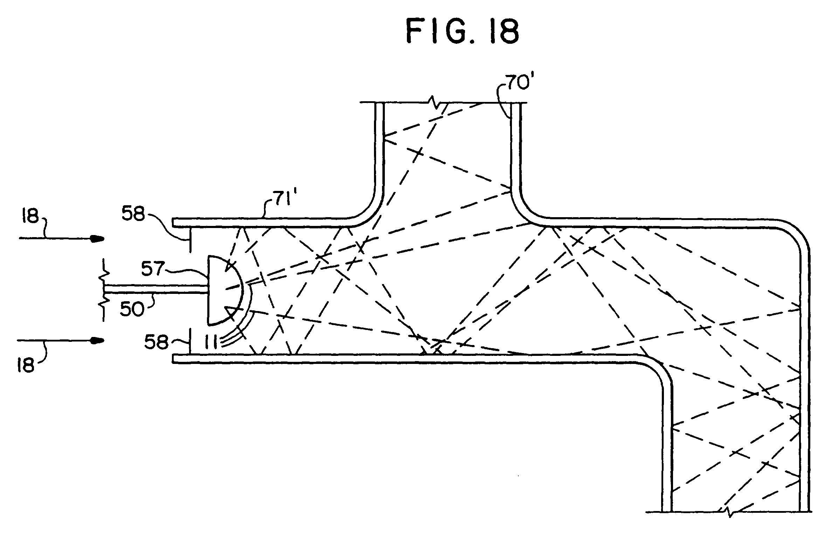

Where the interior of an elongated, enclosed passage is constructed from sufficiently reflective material, such as basic annealed 316 stainless steel, a high-energy lamp, or radiation conduit 50 with an optical diffuser 57 mounted to its end, may simply emit radiation 11 at the entrance to the passage and allow resulting radiation 11 to reflectively traverse the interior 70', as shown in Fig. 18. The interior 70' of elongated passage 71' is sufficiently reflective to enable radiation 11 to traverse the interior without moving the source of radiation. Inert gas flow 18, conveyed to the entrance of passage 71' by any means known in the art, ensures particulate is moved downstream once dislodged from substrate surface 70'. In addition, reflector 58, which may also be constructed from 316 stainless steel, is secured to the perimeter of the entrance of passage 71' to prevent back flow of radiation and gas.

It is also anticipated that a liquid, rather than a gas, may serve as the inert medium to carry away contaminants dislodged through irradiation from narrow, elongated passages. Such a modification would be particularly useful in the removal of plaque from the interior walls of blood vessels. In such an application, the applied radiation would be characterized by an energy density and duration between that required to release surface contaminants from the treatment surface and that which would damage or traumatize the composition of the vascular structure. However, such an application is not covered by the scope of the claims.

Analogous to elongated, enclosed passages, apparatus 80, or more particularly cable 52 and cable head 53, may be utilized to clean more expansive interiors such as those of process chambers. In such instances, cable head 53 may be configured without a flare, so that radiation and inert gas are directed straight out the end of the cable along the cable axis. Manual or robotic control may be employed to guide the assembly as it sweeps across such surfaces.

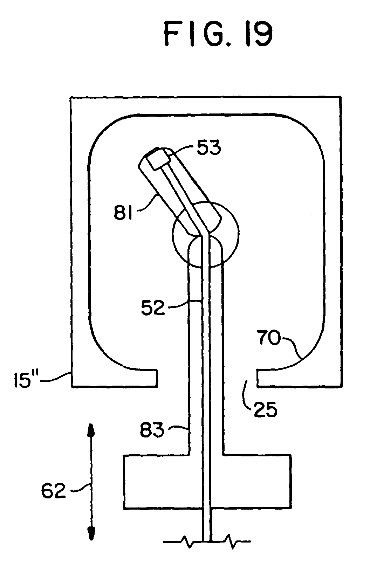

In Fig. 19, for example, chamber 15'' includes a gas inlet embodied in gas passage 55 of cable head 53, and gas outlet 25. Within the chamber, robotic arm 81 attached to base 83 provides means for moving cable head 53 about the interior walls of the chamber, identified as substrate treatment surface 70. The arm may spin a complete 360°, and base 83 may move up and down as denoted by arrow 62 providing complete access to the interior of the chamber. As radiation and gas are conveyed to substrate treatment surface 70 by means of passages 54 and 55 of cable head 53, contaminant is dislodged from the surface and is drawn to outlet 25 by means of gravity and gas flow.

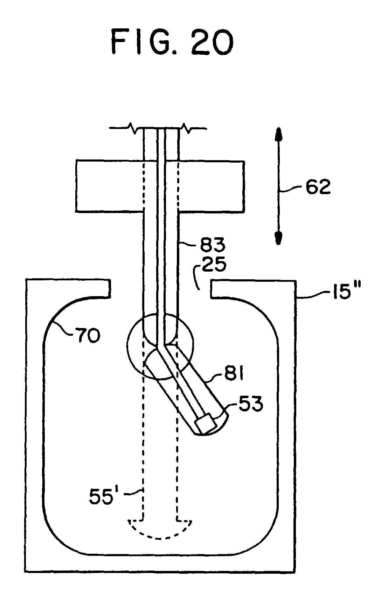

Alternatively, Fig. 20 illustrates a chamber cleaning arrangement wherein the gas outlet 25 is positioned at the top of the chamber. As in Fig. 19, robotic arm 81 attached to base 83 provides means for moving cable head 53 about the interior walls of the chamber. In this instance, however, gravity may not be relied upon to draw dislodged contaminant toward gas outlet 25. As such, a secondary gas flow is provided as indicated by arrow 55' to maintain a constant turbulence at the base of chamber 15''. This secondary flow creates constant movement of gas toward outlet 25 extending the full depth of the chamber. Accordingly, as the substrate surface 70 is cleaned from bottom to top, contaminant is carried by the upward flowing gas stream produced by secondary flow 55' and expelled through outlet 25. It is anticipated that one or more secondary sources of gas may be added to chamber 15'' to accommodate different chamber geometries and gas outlet positions (i.e., side mounting).

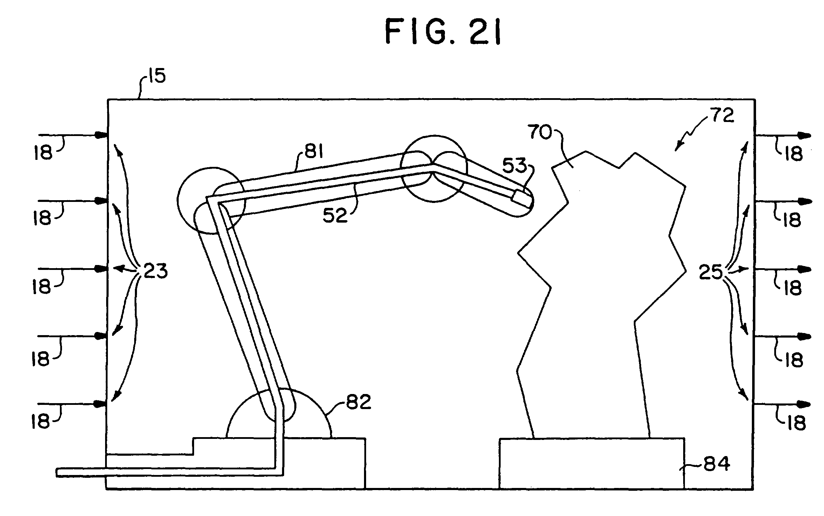

In addition to interiors, cable 52 and cable head 53 may be used to remove contaminant from exteriors of irregularly shaped objects. For example, in Fig. 21, chamber 15' is fitted with gas inlets 23 and outlets 25 to enable a bulk gas flow 18 to traverse the chamber. Within the chamber, robotic arm 81 attached to base 82 provides means for moving cable head 53 about object 72, which includes substrate treatment surface 70. Access to the entire surface 70 of object 72 is facilitated by turntable 84. Passages 54 and 55 within cable head 53 convey radiation and sufficient gas flow to the specific area being treated so to dislodge contaminant from substrate surface 70. Once dislodged from the treatment area, contaminant enters the bulk flow gas stream 18 and is removed front chamber 15' via gas outlet 25. As mentioned above, this exiting gas may be monitored through the use of a gas analyzer and/or particle detector to facilitate selective energy and wavelength adjustment of radiation source 14 (not shown).

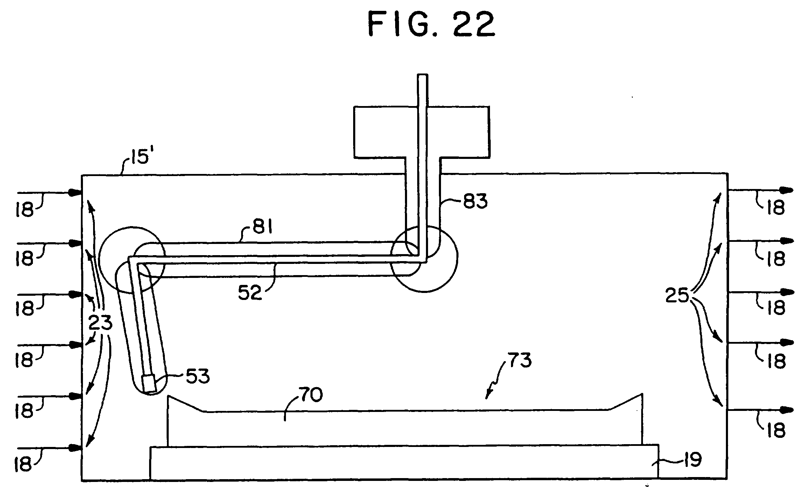

The principles in Fig. 21 apply equally to Fig. 22 wherein object 73 includes a more planar substrate treatment surface 70 such as that found on a painting.

It is anticipated that the exteriors of irregularly shaped objects may be successfully treated through the foregoing process without the use of a chamber, relying solely on gas supplied by conduit 51. Such an apparatus may be in the form of a hand-held device wherein sufficient decontamination is measured by visual inspection rather than through a gas analyzer and/or particle detector.

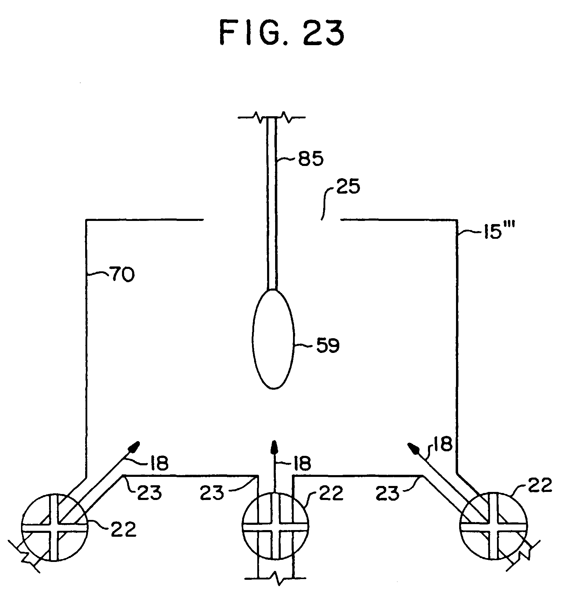

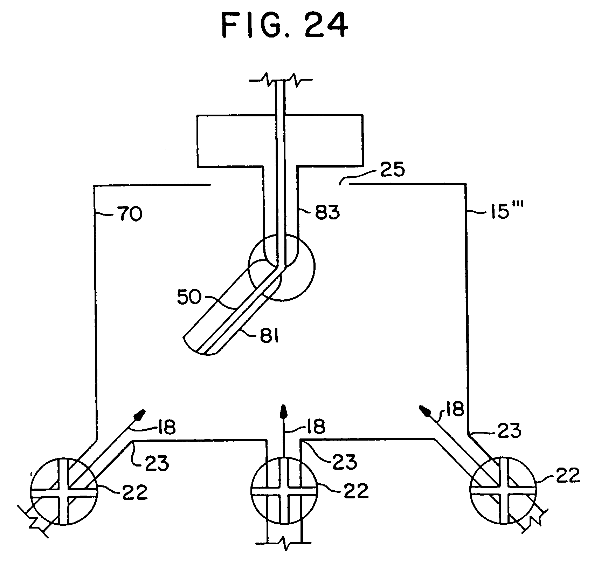

In some irregularly shaped surface applications, it may be advantageous to alter apparatus 80 by separating the gas from the radiation transmission means altogether. For example, when removing contaminants from the interior of a process chamber, one or more radiation sources, such as an ultraviolet lamp, may be placed within the chamber via support 85 as shown in Fig. 23. As the ultraviolet lamp irradiates the chamber interior 70 (substrate treatment surface), gas 18 may be provided from one or more inlets 23 to expel dislodged contaminant from the chamber 15''' via outlet 25. Gas flow 18 may be controlled by valves 22 as described above. Alternatively, radiation may be conveyed to the interior of chamber 15''' via conduit $0 and robotic arm 81 as shown in Fig. 24.

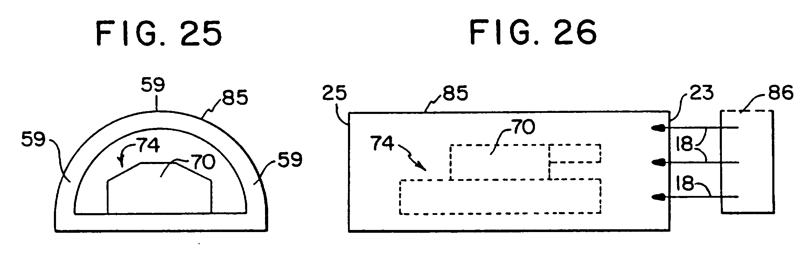

Finally, as illustrated in Figs. 25 and 26, radiation may be generated by means of a bank of high-energy lamps 59 which essentially bathe the substrate treatment surface 70 of object 74 with a sufficient level of radiation to dislodge contaminant. Object 74, which may be an armored vehicle, is exposed to lamps 59 within "Quonset" hut 85, while inert gas 18, accelerated by fan 86, flows over the substrate surface 70. Where geometrically shielded areas may escape the gas turbulence created by fan 86 or radiation generated by bank 59, one or more apparatuses 80 (not shown) may be employed to access these areas.

## Claims

1. An apparatus for removing contaminants from surfaces of a substrate (70) which includes:
a) means (51) for conducting a gas flow to a substrate treatment surface, with the gas being inert to the substrate treatment surface and conducted such that the gas flows across said treatment surface being treated; and
b) means (50) for irradiating a substrate treatment surface while the gas is conducted thereto, said means for irradiating including means for directing irradiation energy to said treatment surface such that the directed irradiation energy intersects a flow direction of the gas flowing across the treatment surface, said irradiation means being designed for generating radiation having an energy density and duration sufficient to release surface contaminants from the substrate treatment surface but insufficient to alter the molecular crystal structure of the substrate treatment surface, and said means for irradiating and said means for conducting a gas flow are dimensioned and arranged such that the irradiation energy gas flow are applied so that the contaminants loosened or released by the irradiation energy from the treatment surface are removed from the treatment surface and carried off within the flow;
said means for conducting a gas flow including a gas conduit having a gas discharge outlet (55)
said means for irradiating including a radiation conduit having a radiation discharge outlet (54); characterized in that said apparatus further comprises a robotic support assembly (81, 83) which controls the position of the gas discharge outlet and said radiation discharge outlet such that the radiation discharge outlet is arranged with respect to said means for conducting a gas flow so as to provide an essentially equal amount of radiation to the substrate surfaces oriented in non-coincident planes while said means for conducting a gas flow places a continuous gas flow along the substrate surfaces being irradiated such that the irradiated energy and gas flow are applied in a coordinated fashion to the substrate surfaces to remove and carry off contaminants contained thereon without altering the molecular crystal structure of the substrate surfaces despite their presence in non-coincident planes.

2. The apparatus of claim 1 wherein said radiation conduit has a base (83) and means for adjusting the base along a single axis.

3. The apparatus of claim 1 wherein said robotic support assembly. radiation conduit and gas conduit are pivotable about an intermediate pivot assembly (82).

4. The apparatus of claim 1 wherein said means for directing a flow of gas includes a secondary flow gas passageway not supported by said robotic support assembly.

5. An apparatus for removing contaminants from a surface of a substrate (70) while preserving the molecular crystal structure of that substrate treatment surface, which includes an irradiating device (14), and a gas flow conductor (51) for conducting a gas flow, inert to the substrate treatment surface, along the substrate treatment surface being irradiated by said irradiating device,
said gas flow conductor including a gas conduit (51) for conveying a gas inert to the substrate treatment surface, said gas conduit having a centrally disposed longitudinal axis,
said irradiating device includes a radiation conduit (50) for conveying radiation to the substrate treatment surface, said radiation conduit having a centrally disposed longitudinal axis, an inlet end and a discharge end (54), characterized in that
a) said gas conduit (51) has a discharge end (55) being movable relative to the treatment surface;
b) said radiation conduit (50) has its discharge end being movable relative to the substrate treatment surface;
c) said irradiating device further includes a source of radiation (14) in communication with said inlet end of said radiation conduit (50) and irradiating into said inlet end radiation which, at the discharge end (54), has an energy density and duration sufficient to release surface contaminants from the substrate treatment surface but insufficient to alter the molecular crystal structure of the substrate treatment surface, said discharge end (54) of said radiation conduit and said discharge end (55) of said gas conduit being disposed so that gas discharged from said gas conduit flows across the portion of the treatment surface being irradiated by radiation discharged from said radiation conduit, and said gas conduit including means for directing the flow of gas from said discharge end of said gas conduit away from the longitudinal axis of said gas conduit and said radiation conduit including means for directing radiation form said discharge end of said radiation conduit away from the longitudinal axis of said radiation conduit.

6. The apparatus of claim 5 wherein at least one of said gas directing means and said radiation directing means is comprised of a multiple passage device (53) mounted at a common discharge end of said gas conduit and said radiation conduit.

7. The apparatus of claim 5 wherein said radiation conduit (50) comprises a light pipe.

8. The apparatus of claim 5 wherein said radiation conduit (50) comprises fiber optics.

9. The apparatus of claim 5 wherein said radiation source (14) is a pulsed laser.

10. The apparatus of claim 9 wherein said pulsed laser operates in the ultraviolet range.

11. The apparatus of claim 5 wherein said means for directing the flow of gas and said means for directing radiation each include a flared back portion which redirects a gas and radiation flow from a forward direction away from an inlet of each of said conduits toward the inlet end of said conduits.

12. The apparatus of claim 5 wherein said means for directing the flow of gas includes means for directing the gas sufficiently about the periphery of the gas conduit to center the discharge end of said gas conduit in a central position with respect to a surrounding enclosure by way of a peripheral forced gas buffer.

13. The apparatus of claim 5 further comprising an inert gas source and wherein said gas inert to the substrate treatment surface is a chemically inert gas.

14. The apparatus of claim 1 wherein said irradiation means comprises a plurality of radiation sources.

15. The apparatus of claim 1 wherein said irradiation means is a member selected from a group consisting of a pulsed laser, a continuous-wave laser, and a high energy lamp. and the discharge end of said radiation conduit directs all of the irradiation energy away from a central axis of the discharge end of said radiation conduit.

16. The apparatus of claim 1 further comprising a gas analyzer for analyzing contaminant laden discharge gas exiting the outlet, said gas analyzer being designed for determining the composition of contaminants contained in said discharge.

17. The apparatus of claim 1 wherein said gas conduit has a discharge end (55) being movable relative to the treatment surfaces and the discharge end (54) of said radiation conduit directs all of the gas flow away from a central axis of the discharge end of said gas conduit.

18. The apparatus of claim 1 wherein the means for conducting a gas flow includes said gas flow conduit (51) which is movable and a secondary gas flow source.

19. The apparatus of claim 1 wherein said irradiation conduit has a discharge end (54) that is movable by said robotic support assembly (81, 83) along more than one axis within an enclosure (15').

20. The apparatus of claim 1 wherein said gas conduit (51) has a longitudinal axis and a discharge end (55) that is movable relative to the treatment surfaces; and
a) said radiation conduit (50) has a longitudinal axis, an inlet end, and a discharge end (54), said discharge end being movable relative to the substrate treatment surfaces,
b) a source of radiation (14) coupled to said inlet end of said radiation conduit and irradiating into said inlet end radiation having an energy density and duration sufficient to release surface contaminants from the substrate treatment surface but insufficient to alter the molecular crystal structure of the substrate treatment surface, said discharge end of said radiation conduit and said discharge end of said gas conduit being disposed so that gas discharged from said gas conduit flows across the portion of the treatment surface previously irradiated by radiation discharged from said radiation conduit,
c) means coupled to said gas conduit for directing of gas from said discharge end of said gas conduit outwardly away from the longitudinal axis of said gas and
d) means (53) coupled to said radiation conduit for directing radiation from said discharge end of said radiation conduit radially outwardly from the longitudinal axis of said radiation conduit.

21. The apparatus of claim 1 wherein said means for conducting a gas flow includes a flow head (53) adapted for movement to multiple positions along an elongated member which encircles the flow head.

22. The apparatus of claim 1 wherein said means for conducting a gas flow further includes a plurality of inlet conduits with each inlet conduit including a valve which valves are multi-positionable so as to provide for altering the nature of gas flow contact on the treatment surfaces.

23. The apparatus of claim 1 wherein said apparatus for removing contaminants is a pressurized, non-vacuum system dimensioned and arranged such that the substrate being treated is not subjected to a vacuum at any time during removal of contaminants.

24. The apparatus of claim 1 wherein said radiation conduit and said means for conducting a gas flow includes a gas conduit, and said radiation conduit has an outlet that directs radiation away from a central axis of said radiation conduit and said gas conduit has an outlet that directs gas away from the central axis of said gas conduit.

25. The apparatus of claim 24 wherein the outlets of said gas and radiation conduits (50, 51) are flared outward and positioned so as to direct gas and radiation forward of the outlet end of said conduits with the gas outlet (55) being positioned radially externally to said radiation outlet (54).

26. The apparatus as recited in claim 24 wherein a gas and a radiation passageway of said gas and radiation conduits have outlet end sections in a common nozzle head that flare back toward an inlet end section of said gas and radiation conduits such that the gas conduit is radially inward of said radiation passage at its inlet end section and radially external to said radiation conduit at its outlet end section.

27. The apparatus as recited in claim 26 further comprising an outlet nozzle which receives the outlet end of said radiation and gas conduits and a gas blocking cap mounted on said nozzle and having a diameter larger than that of said nozzle.

28. The apparatus as recited in claim 1 wherein said radiation conduit (50) has an inlet end and an outlet end and a plurality of pivot sections in said radiation conduit between said inlet and outlet ends.

29. A method for removing contaminants from a substrate comprising directing a gas flow to the substrate treatment surface (70) with means for conducting a gas (51), with the gas being inert to the substrate treatment surface and conducted such that the gas flow flows across said treatment surface;
a) directing radiation to the substrate treatment surface with means for irradiating (50) while the gas is directed thereover, said irradiating step including directing radiation to said treatment surface with an energy density and duration sufficient to release surface contaminants from the substrate treatment surface but insufficient to alter the molecular crystal structure of the substrate treatment surface, said directing of gas flow and radiation to the substrate treatment surface being conducted such that the irradiation energy and the gas flow are applied such that the directed irradiation energy intersects a flow direction of the gas flowing across said treatment surface and so that the gas flow removes contaminants loosened or released by the irradiation energy from the treatment surface, characterized in that
b) a continuous gas flow from said means for conducting a gas flow (51) is placed into contact with, and flows along a plurality of treatment surfaces of a substrate which are oriented in non-coincident planes, and
c) radiation is directed to said plurality of noncoincident treatment surfaces so as to provide an essentially equal amount of radiation to the substrate treatment surfaces oriented in non-coincident planes while said means for conducting a gas flow places a continuous gas flow along the substrate treatment surfaces being irradiated such that the irradiated energy and gas flow intersect and are applied in a coordinated fashion to remove and carry off contaminants contained thereon without altering the molecular crystal structure of the substrate treatment surfaces despite their presence in non-coincidental planes.

30. A method as recited in claim 29 wherein irradiating and directing a gas flow includes irradiating and directing a gas flow with a combination radiation and gas conduit assembly (53) having an inlet end and an outlet end and said irradiating includes inserting the outlet end of said radiation and gas conduit assembly into an elongated enclosure (70) and directing radiation radially outward away from the central axis of said radiation and gas conduit assembly to the non-coincident substrate treatment surfaces defined by the elongated enclosure, and directing said gas flow includes directing the gas flow radially outward from the central axis of said radiation and gas conduit assembly to the non-coincident treatment surfaces being irradiated.

31. A method as recited in claim 29 wherein the noncoincident treatment surfaces are defined by an interior of an elongated cylindrical pipe (70) and providing a gas flow includes directing a gas flow out of a gas conduit with an opening (55 adjacent to an outlet (54) for a radiation conduit of said irradiating means and said gas conduit opening being positioned with respect to the radiation conduit outlet whereby said gas flow contacts the non-coincidental treatment surfaces upstream from a contact location for the radiation directed outwardly from said radiation conduit such that the gas flow is redirected in a flow direction that extends along the elongated enclosure which flow direction intersects with the radiation directed outwardly from said radiation conduit.

32. A method as recited in claim 29 wherein providing a continuous gas flow to the non-coincident treatment surfaces includes adjusting in position a source of said continuous gas flow so as to adjust the continuous gas flow in conformity with changes in orientation of the non-coincident treatment surfaces.

33. A method as recited in claim 29 wherein said means for directing a gas flow includes a main gas flow conduit which is adjustable in position and a second gas flow source which provides a continuous, non adjusted steady stream of gas flow (55') past the substrate while said main gas flow conduit is directing a primary gas flow against the substrate.

34. An apparatus as recited in claim 5 further comprising an enclosure (15) for enclosing the substrate being treated and a secondary gas flow source which is used in conjunction with the gas flow provided by said gas flow conductor.

35. An apparatus as recited in claim 1 further comprising a support (84) for the substrate (70) being treated, and said means for irradiating (53) and said means for conducting a gas flow (53) being adjustable to irradiate and apply a gas flow to each of the non-coincidental surfaces being treated while the substrate is fixed in a single position during treatment of the non-coincidental treatment surfaces.

## Patentansprüche

1. Apparat zum Entfernen von Verunreinigungen von den Oberflächen eines Substrats (70), umfassend:
a) Mittel (51), um einen Gasstrom auf eine Substrat-Behandlungsoberfläche zu leiten, wobei das Gas bezüglich der Substrat-Behandlungsoberfläche inert ist, und so darauf geleitet wird, daß es über die zu behandelnde Behandlungsoberfläche strömt; und
b) Mittel (50), um eine Substrat-Behandlungsoberfläche zu bestrahlen, während das Gas darauf geleitet wird, wobei die Mittel zum Bestrahlen Mittel umfassen, um die Bestrahlungsenergie so auf die Behandlungsoberfläche zu lenken, daß die darauf gelenkte Strahlungsenergie die Strömungsrichtung des über die Behandlungsoberfläche strömenden Gases schneidet, wobei die Bestrahlungsmittel ausgelegt sind, um Strahlung zu erzeugen, die eine Energiedichte und Dauer hat, die ausreichen, um Oberflächenverunreinigungen von der Substrat-Behandlungsoberfläche freizugeben, aber nicht ausreichen, um die molekulare Kristallstruktur der Substrat-Behandlungsoberfläche zu verändern, und die Mittel zum Bestrahlen und die Mittel zum Leiten eines Gasstroms so dimensioniert und ausgelegt sind, daß der Strahlungsenergiegasstrom so aufgebracht werden, daß die durch die Bestrahlungsenergie von der Behandlungsoberfläche abgelösten oder freigegebenen Verunreinigungen von der Behandlungsoberfläche entfernt werden und innerhalb des Gasstroms abgeführt werden;
wobei die Mittel zum Leiten eines Gasstroms eine Gasleitung umfassen, die einen Gasabgabeauslaß (55) hat;
wobei die Mittel zum Bestrahlen eine Bestrahlungsleitung umfassen, die einen Strahlungsabgabeauslaß (54) hat; dadurch gekennzeichnet, daß
der Apparat weiterhin eine Roboter-Trageinheit (81, 83) aufweist, die die Position des Gasabgabeauslasses und des Strahlungsabgabeauslasses so steuert, daß der Strahlungsabgabeauslaß bezüglich der Mittel zum Leiten eines Gasstroms so angeordnet ist, daß eine im wesentlichen gleiche Strahlungsmenge auf die in nicht-übereinstimmenden Ebenen liegenden Substratoberflächen gegeben wird, während die Mittel zum Leiten eines Gasstroms einen kontinuierlichen Gasstrom längs der zu bestrahlenden Substratoberflächen hervorrufen, so daß die Bestrahlungsenergie und der Gasstrom auf koordinierte Weise auf die Substratoberflächen aufgebracht werden, um die darauf festgehaltenen Verunreinigungen zu entfernen und abzuführen, ohne die molekulare Kristallstruktur der Substratoberflächen zu verändern, obwohl die Substratoberflächen in nicht-übereinstimmenden Ebenen liegen.

2. Apparat gemäß Anspruch 1, wobei die Strahlungsleitung eine Basis (83) und Mittel zum Einstellen der Basis längs einer einzigen Achse hat.

3. Apparat gemäß Anspruch 1, wobei die Roboter-Trageinheit, die Strahlungsleitung und die Gasleitung um eine Zwischenschwenkeinheit (82) schwenkbar sind.

4. Apparat gemäß Anspruch 1, wobei die Mittel zum Lenken eines Gasstroms einen nicht von der Roboter-Trageinheit getragenen Durchgang für einen sekundären Gasstrom umfassen.

5. Apparat zum Entfernen von Verunreinigungen von einer Oberfläche eines Substrats (70), während die molekulare Kristallstruktur der Substrat-Behandlungsoberfläche erhalten bleibt, umfassend eine Bestrahlungsvorrichtung (14), und ein Gasstromleiter (51), um einen bezüglich der Substrat-Behandlungsoberfläche inerten Gasstrom längs der durch die Bestrahlungsvorrichtung zu bestrahlenden Substrat-Behandlungsoberfläche zu leiten,
wobei der Gasstromleiter eine Gasleitung (51) umfaßt, um ein bezüglich der Substrat-Behandlungsoberfläche inertes Gas zu befördern, wobei die Gasleitung eine zentral angeordnete Längsachse hat,
wobei die Bestrahlungsvorrichtung eine Strahlungsleitung (50) umfaßt, um Strahlung nach der Substrat-Behandlungsoberfläche zu befördern, wobei die Strahlungsleitung eine zentral angeordnete Längsachse, ein Einlaßende und ein Abgabeende (54) umfaßt, dadurch gekennzeichnet, daß
a) die Gasleitung (51) ein Abgabeende (55) hat, das relativ zu der Behandlungsoberfläche bewegbar ist;
b) die Strahlungsleitung (50) ein Abgabeende hat, das relativ zu der Substrat-Behandlungsoberfläche bewegbar ist;
c) die Bestrahlungsvorrichtung weiterhin eine Strahlungsquelle (14) umfaßt, die in Verbindung mit dem Einlaßende der Strahlungsleitung (50) steht und in das Einlaßende Strahlung einfallen läßt, die an dem Abgabeende (54) eine Energiedichte und Dauer hat, die ausreichen, um Oberflächenverunreinigungen von der Substrat-Behandlungsoberfläche freizugeben, aber nicht ausreichen, um die molekulare Kristallstruktur der Substrat-Behandlungsoberfläche zu verändern, wobei das Abgabeende (54) der Strahlungsleitung und das Abgabeende (55) der Gasleitung so angeordnet sind, daß das von der Gasleitung abgegebene Gas über den Bereich der Behandlungsoberfläche strömt, der durch von der Strahlungsleitung abgegebene Strahlung bestrahlt wird, und die Gasleitung Mittel umfaßt, um den Gasstrom bei dem Abgabeende der Gasleitung von der Längsachse der Gasleitung weg zu lenken, und die Strahlungsleitung Mittel umfaßt, um Strahlung bei dem Abgabeende der Strahlungsleitung von der Längsachse der Strahlungsleitung weg zu lenken.

6. Apparat gemäß Anspruch 5, wobei mindestens entweder die Gaslenkungsmittel oder die Strahlungslenkungsmittel aus einer Multidurchgangsvorrichtung (53) bestehen, die bei einem gemeinsamen Abgabeende der Gasleitung und der Strahlungsleitung angebracht ist.

7. Apparat gemäß Anspruch 5, wobei die Strahlungsleitung (50) ein Lichtleiter aufweist.

8. Apparat gemäß Anspruch 5, wobei die Strahlungsleitung (50) Faseroptiken aufweist.

9. Apparat gemäß Anspruch 5, wobei die Strahlungsquelle (14) ein gepulster Laser ist.

10. Apparat gemäß Anspruch 9, wobei der gepulste Laser in dem ultravioletten Bereich arbeitet.

11. Apparat gemäß Anspruch 5, wobei die Mittel zum Lenken des Gasstroms und die Mittel zum Lenken der Strahlung jeweils einen nach hinten umgebogenen Bereich umfassen, der den Gasstrom und die Strahlung von der Vorwärtsrichtung bei dem Einlaß von jeder der Leitungen weg zu dem Einlaßende der Leitungen hin umlenkt.

12. Apparat gemäß Anspruch 5, wobei die Mittel zum Lenken des Gasstroms Mittel umfassen, um das Gas in genügender Weise um den Umfang der Gasleitung herum zu lenken, um das Abgabeende der Gasleitung mittels einer peripheren Zwangsgaspuffers in einer zentralen Position bezüglich einer umgebenden Umhüllung zu zentrieren.

13. Apparat gemäß Anspruch 5, der weiterhin eine Inertgasquelle aufweist, wobei das bezüglich der Substrat-Behandlungsoberfläche inerte Gas ein chemisch inertes Gas ist.

14. Apparat gemäß Anspruch 1, wobei die Bestrahlungsmittel eine Vielzahl von Strahlungsquellen aufweisen.

15. Apparat gemäß Anspruch 1, wobei die Bestrahlungsmittel ein Element sind, das aus einer Gruppe ausgewählt ist, die aus einem gepulsten Laser, einem Dauerstrichlaser, und einer Hochenergielampe besteht, und das Abgabeende der Strahlungsleitung die ganze Bestrahlungsenergie von der zentralen Achse des Abgabeendes der Strahlungsleitung weg lenkt.

16. Apparat gemäß Anspruch 1, der weiterhin einen Gasanalysator aufweist, um mit Verunreinigungen beladenes Abgabegas, das aus dem Auslaß herauskommt, zu analysieren, wobei der Gasanalysator ausgelegt ist, um die Zusammensetzung der in dem Abgabegas enthaltenen Verunreinigungen zu bestimmen.

17. Apparat gemäß Anspruch 1, wobei die Gasleitung ein Abgabeende (55) hat, das relativ zu den Behandlungsoberflächen bewegbar ist, und das Abgabeende (54) der Strahlungsleitung den ganzen Gasstrom von der zentralen Achse des Abgabeendes der Gasleitung weg lenkt.

18. Apparat gemäß Anspruch 1, wobei die Mittel zum Leiten eines Gasstroms die Gasstromleitung (51), die bewegbar ist, und eine Quelle eines sekundären Gasstroms umfassen.

19. Apparat gemäß Anspruch 1, wobei die Bestrahlungsleitung ein Abgabeende (54) hat, das durch die Roboter-Trageinheit (81, 83) innerhalb einer Umhüllung (15') längs mehr als einer Achse bewegbar ist.

20. Apparat gemäß Anspruch 1, wobei die Gasleitung (51) eine Längsachse hat, und ein Abgabeende (55) hat, das relativ zu den Behandlungsoberflächen bewegbar ist; und
a) die Strahlungsleitung (50) eine Längsachse, ein Einlaßende, und eine Abgabeende (54) hat, wobei das Abgabeende relativ zu den Substrat-Behandlungsoberflächen bewegbar ist,
b) eine Strahlungsquelle (14), die mit dem Einlaßende der Strahlungsleitung gekoppelt ist, und in das Einlaßende Strahlung einfallen läßt, die eine Energiedichte und Dauer hat, die ausreichen, um Oberflächenverunreinigungen von der Substrat-Behandlungsoberfläche freizugeben, aber nicht ausreichen, um die molekulare Kristallstruktur der Substrat-Behandlungsoberfläche zu verändern, wobei das Abgabeende der Strahlungsleitung und das Abgabeende der Gasleitung so angeordnet sind, daß das von der Gasleitung abgegebene Gas über den Bereich der Behandlungsoberfläche strömt, der zuvor mit der von der Strahlungsleitung abgegebenen Strahlung bestrahlt wurde,
c) Mittel, die mit der Gasleitung gekoppelt sind, um das Gas bei dem Abgabeende der Gasleitung von der Längsachse des Gasstroms weg nach außen zu lenken, und
d) Mittel (53), die mit der Strahlungsleitung gekoppelt sind, um die Strahlung bei dem Abgabeende der Strahlungsleitung von der Längsachse der Strahlungsleitung radial nach außen zu lenken.

21. Apparat gemäß Anspruch 1, wobei die Mittel zum Leiten eines Gasstroms einen Strömungskopf (53) umfassen, der für die Bewegung nach mehreren Positionen längs eines länglichen Elements, das den Strömungskopf umgibt, ausgelegt ist.

22. Apparat gemäß Anspruch 1, wobei die Mittel zum Leiten eines Gasstroms weiterhin eine Vielzahl von Einlaßleitungen umfassen, wobei jede Einlaßleitung ein Ventil umfaßt, und die Ventile in mehreren Positionen angeordnet werden können, so daß sie eine Veränderung der Art des Gasstromkontakts auf den Behandlungsoberflächen bewirken.

23. Apparat gemäß Anspruch 1, wobei der Apparat zum Entfernen von Verunreinigungen ein unter Druck stehendes Nicht-Vakuum-System ist, das so dimensioniert und ausgelegt ist, daß das zu behandelnde Substrat während der Entfernung der Verunreinigungen zu keiner Zeit einem Vakuum unterworfen wird.

24. Apparat gemäß Anspruch 1, wobei die Strahlungsleitung und die Mittel zum Leiten eines Gasstroms eine Gasleitung umfassen, und die Strahlungsleitung einen Auslaß hat, der die Strahlung von der zentralen Achse der Strahlungsleitung weg lenkt, und die Gasleitung einen Auslaß hat, der das Gas von der zentralen Achse der Gasleitung weg lenkt.

25. Apparat gemäß Anspruch 24, wobei die Auslässe der Gas- und der Strahlungsleitung (50, 51) nach außen gebogen sind, und so angeordnet sind, daß sie das Gas und die Strahlung bei dem Auslaßende der Leitungen nach vorne lenken, wobei der Gasauslaß (55) radial außerhalb des Strahlungsauslasses (54) angeordnet ist.

26. Apparat gemäß Anspruch 24, wobei ein Gas- und ein Strahlungsdurchgang der Gas- und der Strahlungsleitung Auslaßende-Abschnitte in einem gemeinsamen Düsenkopf haben, die nach hinten zu einem Einlaßende-Abschnitt der Gas- und der Strahlungsleitung hin umgebogen sind, so daß die Gasleitung bei ihrem Einlaßende-Abschnitt radial innerhalb des Strahlungsdurchgangs, und bei ihrem Auslaßende-Abschnitt radial außerhalb der Strahlungsleitung angeordnet ist.

27. Apparat gemäß Anspruch 26, der weiterhin eine Auslaßdüse aufweist, die das Auslaßende der Strahlungs- und der Gasleitung aufnimmt, und eine Gasblockierkappe aufweist, die auf der Düse angebracht ist und einen Durchmesser hat, der größer als derjenige der Düse ist.

28. Apparat gemäß Anspruch 1, wobei die Strahlungsleitung (50) ein Einlaßende und ein Auslaßende, und zwischen dem Einlaß- und dem Auslaßende eine Vielzahl von Schwenkabschnitten in der Strahlungsleitung hat.

29. Verfahren zum Entfernen von Verunreinigungen von einem Substrat, wobei bei diesem Verfahren ein Gasstrom mit Mitteln (51) zum Leiten eines Gases auf die Substrat-Behandlungsoberfläche (70) gelenkt wird, wobei das Gas bezüglich der Substrat-Behandlungsoberfläche inert ist, und so geleitet wird, daß es über die zu behandelnde Behandlungsoberfläche strömt; und
a) Strahlung mit Mitteln (50) zum Bestrahlen, die auf die Substrat-Behandlungsoberfläche gelenkt wird, während das Gas darüber gelenkt wird, wobei bei dem Bestrahlungsschritt Strahlung auf die Behandlungsoberfläche gelenkt wird, und diese Strahlung eine Energiedichte und Dauer hat, die ausreichen, um Oberflächenverunreinigungen von der Substrat-Behandlungsoberfläche freizugeben, aber nicht ausreichen, um die molekulare Kristallstruktur der Substrat-Behandlungsoberfläche zu verändern, und das Lenken des Gasstroms und der Strahlung auf die Substrat-Behandlungsoberfläche so ausgeführt wird, daß die Bestrahlungsenergie und der Gasstrom so aufgebracht werden, daß die gelenkte Bestrahlungsenergie die Strömungsrichtung des über die Behandlungsoberfläche strömenden Gasstroms schneidet, und der Gasstrom Verunreinigungen entfernt, die durch die Bestrahlungsenergie von der Behandlungsoberfläche abgelöst oder freigegeben werden, dadurch gekennzeichnet, daß
b) ein kontinuierlicher Gasstrom von dem Mitteln (51) zum Leiten eines Gasstroms in Kontakt mit einer Vielzahl von Behandlungsoberflächen eines Substrats gebracht wird, die in nichtübereinstimmenden Ebenen liegen, und
c) Strahlung auf die Vielzahl von nicht-übereinstimmenden Behandlungsoberflächen gelenkt wird, so daß eine im wesentlichen gleiche Strahlungsmenge auf die in nicht-übereinstimmenden Ebenen liegenden Substrat-Behandlungsoberflächen auffällt, während die Mittel zum Leiten eines Gasstroms einen kontinuierlichen Gasstrom längs der Substrat-Behandlungsoberflächen hervorrufen, die so bestrahlt werden, daß die Bestrahlungsenergie und der Gasstrom sich schneiden und in einer koordinierten Weise aufgebracht werden, um darauf festgehaltene Verunreinigungen zu entfernen und abzuführen, ohne die molekulare Kristallstruktur der Substrat-Behandlungsoberflächen zu verändern, obwohl die Substrat-Behandlungsoberflächen in nicht-übereinstimmenden Ebenen liegen.

30. Verfahren gemaß Anspruch 29, wobei das Bestrahlen und das Lenken eines Gasstroms das Bestrahlen und das Lenken eines Gasstroms mit einer Strahlungs- und Gas-Kombinationsleitungseinheit (53) umfaßt, die ein Einlaßende und ein Auslaßende hat, und das Bestrahlen das Einsetzen des Auslaßendes der Strahlungs- und Gasleitungseinheit in eine längliche Umhüllung (70) und das Lenken der Strahlung von der zentralen Achse der Strahlungs- und Gasleitungseinheit weg radial nach außen auf die durch die längliche Umhüllung definierten, nicht-übereinstimmenden Substrat-Behandlungsoberflächen umfaßt, und das Lenken des Gasstroms das Lenken des Gasstroms von der zentralen Achse der Strahlungs- und Gasleitungseinheit weg radial nach außen auf die zu bestrahlenden, nicht-übereinstimmenden Behandlungsoberflächen umfaßt.

31. Verfahren gemäß Anspruch 29, wobei die nichtübereinstimmenden Behandlungsoberflächen durch das Innere eines länglichen, zylindrischen Rohrs (70) definiert sind, und das Zuführen eines Gasstroms das Lenken eines Gasstroms aus einer Gasleitung heraus umfaßt, die eine Öffnung (55) hat, die an einen Auslaß (54) für eine Strahlungsleitung der Bestrahlungsmittel angrenzt, und die Gasleitungsöffnung bezüglich des Strahlungsleitungsauslasses positioniert ist, wodurch der Gasstrom die nicht-übereinstimmenden Behandlungsoberflächen stromaufwärts von einer Kontaktstelle für die Strahlung berührt, die von der Strahlungsleitung so nach außen gelenkt wird, daß der Gasstrom in eine Strömungsrichtung umgelenkt wird, die sich längs der länglichen Umhüllung erstreckt, wobei diese Strömungsrichtung die von der Strahlungsleitung nach außen gelenkte Strahlung schneidet.

32. Verfahren gemäß Anspruch 29, wobei das Zuführen eines kontinuierlichen Gasstroms auf die nicht-übereinstimmenden Behandlungsoberflächen das Einstellen der Position einer Quelle des kontinuierlichen Gasstroms umfaßt, wobei der kontinuierliche Gasstrom entsprechend den Änderungen der Orientierung der nichtübereinstimmenden Behandlungsoberflächen eingestellt wird.

33. Verfahren gemäß Anspruch 29, wobei die Mittel zum Lenken eines Gasstroms eine Leitung für einen Hauptgasstrom umfassen, deren Position einstellbar ist, und eine Quelle eines zweiten Gasstroms umfassen, die einen kontinuierlichen, nicht-eingestellten, gleichmäßigen Gasstrom (55') über das Substrat hinweg liefert, während die Leitung für den Hauptgasstrom einen primären Gasstrom auf das Substrat lenkt.

34. Apparat gemäß Anspruch 5, der weiterhin eine Umhüllung (15) aufweist, um das zu behandelnde Substrat zu umhüllen, und eine Quelle eines sekundären Gasstroms aufweist, die in Verbindung mit dem von dem Gasstromrohr gelieferten Gasstrom verwendet wird.

35. Apparat gemäß Anspruch 1, der weiterhin einen Träger (84) für das zu behandelnde Substrat (70) aufweist, wobei die Mittel (53) zum Bestrahlen und die Mittel (53) zum Leiten eines Gasstroms einstellbar sind, um jede der zu behandelnden, nichtübereinstimmenden Oberflächen zu bestrahlen und einen Gasstrom darauf aufzubringen, während das Substrat bei der Behandlung der nicht-übereinstimmenden Behandlungsoberflächen in einer einzigen Position festgehalten wird.

## Revendications

1. Appareil pour l'enlèvement de contaminants des surfaces d'un substrat (70) comprenant :
a) des moyens (51) pour conduire un courant gazeux jusqu'à une surface de traitement du substrat, le gaz étant inerte sur la surface de traitement du substrat et amené de telle sorte que le gaz s'écoule au travers de la surface de traitement traitée; et
b) des moyens (50) pour irradier une surface de traitement du substrat tandis que le gaz y est amené, lesdits moyens d'irradiation comprenant des moyens pour diriger l'énergie d'irradiation sur ladite surface de traitement de telle sorte que l'énergie d'irradiation dirigée coupe une direction d'écoulement du gaz s'écoulant au travers de la surface de traitement, lesdits moyens d'irradiation étant conçus pour générer un rayonnement ayant une densité et une durée d'énergie suffisantes pour libérer les contaminants de surface de la surface de traitement du substrat mais insuffisantes pour modifier la structure cristalline moléculaire de la surface de traitement du substrat, et lesdits moyens d'irradiation et lesdits moyens d'amenée d'un courant gazeux sont dimensionnés et disposés de telle sorte que le courant gazeux d'énergie d'irradiation est appliqué afin que les contaminants détachés ou libérés par l'énergie d'irradiation de la surface de traitement soient enlevés de la surface de traitement et emportés dans l'écoulement;
lesdits moyens pour conduire un courant gazeux comprenant une conduite de gaz ayant un orifice de décharge de gaz (55),
lesdits moyens d'irradiation comprenant une conduite de rayonnement ayant un orifice de décharge de rayonnement (54); caractérisé en ce que ledit appareil comprend en outre un ensemble support d'automate (81, 83) qui commande la position de l'orifice de décharge de gaz et dudit orifice de décharge de rayonnement de telle sorte que l'orifice de décharge de rayonnement soit disposé par rapport auxdits moyens pour conduire un courant gazeux afin de fournir une quantité essentiellement égale de rayonnement jusqu'aux surfaces du substrat orientées dans des plans non coïncidents tandis que lesdits moyens pour conduire un courant gazeux appliquent un courant gazeux continu sur les surfaces du substrat irradié afin que l'énergie irradiée et le courant gazeux soient appliqués de manière coordonnée sur les surfaces du substrat pour enlever et emporter les contaminants déposés dessus sans modifier la structure cristalline moléculaire des surfaces du substrat malgré leur présence dans des plans non coïncidents.

2. Appareil selon la revendication 1, dans lequel ladite conduite de rayonnement a une base (83) et des moyens pour ajuster la base le long d'un axe unique.

3. Appareil selon la revendication 1, dans lequel ledit ensemble support d'automate, la conduite de rayonnement et la conduite de gaz peuvent pivoter autour d'un ensemble à pivot intermédiaire (82).

4. Appareil selon la revendication 1, dans lequel lesdits moyens pour diriger un courant gazeux comprennent un passage de courant gazeux secondaire non supporté par ledit ensemble support d'automate.

5. Appareil pour l'enlèvement de contaminants d'une surface d'un substrat (70) tout en préservant la structure cristalline moléculaire de cette surface de traitement du substrat, lequel comprend un dispositif d'irradiation (14), et un conducteur de courant gazeux (51) pour diriger un courant gazeux, inerte sur la surface de traitement du substrat, sur la surface de traitement du substrat irradié par ledit appareil d'irradiation,
ledit conducteur de courant gazeux comprenant une conduite de gaz (51) pour amener un gaz inerte sur la surface de traitement du substrat, ladite conduite de gaz ayant un axe longitudinal placé centralement,
ledit appareil d'irradiation comprend une conduite de rayonnement (50) pour amener le rayonnement jusqu'à la surface de traitement du substrat, ladite conduite d'irradiation ayant un axe longitudinal placé centralement, une extrémité d'entrée et une extrémité de décharge (54); caractérisé en ce que
a) ladite conduite de gaz (51) a une extrémité de décharge mobile par rapport à la surface de traitement;
b) ladite conduite de rayonnement (50) a son extrémité de décharge mobile par rapport à ladite surface de traitement du substrat;
c) ledit appareil d'irradiation comprend en outre une source de rayonnement (14) en communication avec ladite extrémité d'entrée de ladite conduite de rayonnement (50) et irradiant dans ledit rayonnement d'extrémité d'entrée qui, à l'extrémité de décharge (54), a une densité et une durée d'énergie suffisantes pour libérer les contaminants de surface de la surface de traitement du substrat mais insuffisantes pour modifier la structure cristalline moléculaire de la surface de traitement du substrat, ladite extrémité de décharge (54) de ladite conduite de rayonnement et ladite extrémité de décharge (55) de ladite conduite de gaz étant placées de telle sorte que le gaz déchargé de ladite conduite de gaz s'écoule au travers de la partie de la surface de traitement irradiée par le rayonnement déchargé de ladite conduite de rayonnement, et ladite conduite de gaz comprenant des moyens pour dévier le courant gazeux de ladite extrémité de décharge de ladite conduite de gaz de l'axe longitudinal de ladite conduite de gaz et ladite conduite de rayonnement comprenant des moyens pour dévier le rayonnement de ladite extrémité de décharge de ladite conduite de rayonnement de l'axe longitudinal de ladite conduite de rayonnement.

6. Appareil selon la revendication 5, dans lequel au moins un desdits moyens de direction de gaz et desdits moyens de direction de rayonnement est constitué d'un dispositif à passages multiples (53) monté à une extrémité de décharge commune de ladite conduite de gaz et de ladite conduite de rayonnement.

7. Appareil selon la revendication 5, dans lequel ladite conduite de rayonnement (50) comprend un tube lumineux.

8. Appareil selon la revendication 5, dans lequel ladite conduite de rayonnement (50) comprend des fibres optiques.

9. Appareil selon la revendication 5, dans lequel ladite source de rayonnement (14) est un laser pulsé.

10. Appareil selon la revendication 9, dans lequel ledit laser pulsé fonctionne dans le champ de l'ultraviolet.

11. Appareil selon la revendication 5, dans lequel lesdits moyens pour diriger le courant gazeux et lesdits moyens pour diriger le rayonnement comprennent chacun une partie arrière évasée qui redirige un écoulement de gaz et de rayonnement d'une direction avant écartée d'une entrée de chacune desdites conduites vers l'extrémité d'entrée desdites conduites.

12. Appareil selon la revendication 5, dans lequel lesdits moyens pour diriger le courant gazeux comprennent des moyens pour diriger le gaz suffisamment autour de la périphérie de la conduite de gaz pour centrer l'extrémité de décharge de ladite conduite de gaz dans une position centrale par rapport à une enceinte périphérique au moyen d'un amortisseur périphérique à gaz forcé.

13. Appareil selon la revendication 5 comprenant en outre une source de gaz inerte et dans lequel ledit gaz inerte sur la surface de traitement du substrat est un gaz chimiquement inerte.

14. Appareil selon la revendication 1, dans lequel lesdits moyens d'irradiation comprennent plusieurs sources de rayonnement.

15. Appareil selon la revendication 1, dans lequel lesdits moyens d'irradiation sont un élément sélectionné dans un groupe constitué d'un laser pulsé, d'un laser à faisceau continu, et d'une lampe à haute énergie, et l'extrémité de décharge de ladite conduite de rayonnement dévie toute l'énergie d'irradiation d'un axe central de l'extrémité de décharge de ladite conduite de rayonnement.

16. Appareil selon la revendication 1 comprenant en outre un analyseur de gaz pour analyser le gaz de décharge chargé en contaminants sortant de la sortie, ledit analyseur de gaz étant conçu pour déterminer la composition des contaminants contenus dans ledit gaz de décharge.

17. Appareil selon la revendication 1, dans lequel ladite conduite de gaz a une extrémité de décharge (55) mobile par rapport aux surfaces de traitement et l'extrémité de décharge (54) de ladite conduite de rayonnement dévie la totalité du courant gazeux d'un axe central de l'extrémité de décharge de ladite conduite de gaz.

18. Appareil selon la revendication 1, dans lequel les moyens pour diriger un courant gazeux comprennent une conduite de courant gazeux (51) qui est mobile et une source de courant gazeux secondaire.

19. Appareil selon la revendication 1, dans lequel ladite conduite de rayonnement a une extrémité de décharge (54) qui est mobile par ledit ensemble support d'automate (81, 83) sur plus d'un axe à l'intérieur d'une enceinte (15').

20. Appareil selon la revendication 1, dans lequel ladite conduite de gaz (51) a un axe longitudinal et une extrémité de décharge (55) qui est mobile par rapport aux surfaces de traitement; et
a) ladite conduite de rayonnement (50) a un axe longitudinal, une extrémité d'entrée, et une extrémité de décharge (54), ladite extrémité de décharge étant mobile par rapport aux surfaces de traitement du substrat,
b) une source de rayonnement (14) couplée à ladite extrémité d'entrée de ladite conduite de rayonnement et irradiant dans ledit rayonnement d'extrémité d'entrée ayant une densité et une durée d'énergie suffisantes pour libérer les contaminants de surface de la surface de traitement du substrat mais insuffisantes pour modifier la structure cristalline moléculaire de la surface de traitement du substrat, ladite extrémité de décharge de ladite conduite de rayonnement et ladite extrémité de décharge de ladite conduite de gaz étant placées de telle sorte que le gaz déchargé de ladite conduite de gaz s'écoule au travers de la partie de la surface de traitement précédemment irradiée par le rayonnement déchargé de ladite conduite de rayonnement,
c) des moyens coupés à ladite conduite de gaz pour dévier le gaz de ladite extrémité de décharge de ladite conduite de gaz vers l'extérieur de l'axe longitudinal dudit gaz et
d) des moyens (53) couplés à ladite conduite de rayonnement pour diriger le rayonnement de ladite extrémité de décharge de ladite conduite de rayonnement radialement vers l'extérieur de l'axe longitudinal de ladite conduite de rayonnement.

21. Appareil selon la revendication 1, dans lequel lesdits moyens pour conduire un courant gazeux comprennent une tête d'écoulement (53) adaptée pour se déplacer à des positions multiples sur un élément allongé qui encercle la tête d'écoulement.

22. Appareil selon la revendication 1, dans lequel lesdits moyens pour conduire un courant gazeux comprennent en outre plusieurs conduites d'entrée avec chaque conduite d'entrée comprenant un robinet, lesquels robinets sont à positions multiples afin d'assurer la modification de la nature du contact du courant gazeux sur les surfaces de traitement.

23. Appareil selon la revendication 1, dans lequel ledit appareil pour l'enlèvement de contaminants est un système pressurisé sans dépression et configuré de telle sorte que le substrat traité ne soit pas soumis à un vide à n'importe quel moment pendant l'enlèvement des contaminants.

24. Appareil selon la revendication 1, dans lequel ladite conduite de rayonnement et lesdits moyens pour conduire un courant gazeux comprennent une conduite de gaz, et ladite conduite de rayonnement a une sortie qui dévie le rayonnement d'un axe central de ladite conduite de rayonnement et ladite conduite de gaz a une sortie qui dévie le gaz de l'axe central de ladite conduite de gaz.

25. Appareil selon la revendication 24, dans lequel les sorties desdites conduites de gaz et de rayonnement (50, 51) sont évasées vers l'extérieur et positionnées de manière à diriger le gaz et le rayonnement vers l'avant de l'extrémité de sortie desdites conduites avec la sortie de gaz (55) positionnée radialement à l'extérieur de ladite sortie de rayonnement (54).

26. Appareil selon la revendication 24, dans lequel un passage de gaz et un passage de rayonnement desdites conduites de gaz et de rayonnement ont des sections d'extrémité de sortie dans une tête à buse commune qui s'évase en arrière vers une section d'extrémité d'entrée desdites conduites de gaz et de rayonnement de telle sorte que la conduite de gaz soit radialement vers l'intérieur dudit passage de rayonnement à sa section d'extrémité d'entrée et radialement à l'extérieur de ladite conduite de rayonnement à sa section d'extrémité de sortie.

27. Appareil selon la revendication 26 comprenant en outre une buse de sortie qui reçoit l'extrémité de sortie desdites conduites de rayonnement et de gaz et un bouchon de fermeture de gaz monté sur ladite buse et ayant un diamètre plus grand que celui de ladite buse.

28. Appareil selon la revendication 1, dans lequel ladite conduite de rayonnement (50) a une extrémité d'entrée et une extrémité de sortie et une pluralité de sections à pivots dans ladite conduite de rayonnement entre lesdites extrémités d'entrée et de sortie.

29. Méthode d'enlèvement de contaminants d'un substrat comprenant l'amenée d'un courant gazeux sur la surface de traitement du substrat (70) avec des moyens pour conduire un gaz (51), le gaz étant inerte sur la surface de traitement du substrat et amené de telle sorte que le courant gazeux s'écoule au travers de la surface de traitement;
a) diriger le rayonnement sur la surface de traitement du substrat avec des moyens d'irradiation (50) tandis que le gaz y est amené, ladite étape d'irradiation consistant à diriger le rayonnement sur ladite surface de traitement avec une densité et une durée d'énergie suffisantes pour libérer les contaminants de surface de la surface de traitement du substrat mais insuffisantes pour modifier la structure cristalline moléculaire de la surface de traitement du substrat, ladite amenée du courant gazeux et du rayonnement sur la surface de traitement du substrat étant conduite de telle sorte que l'énergie d'irradiation et le courant gazeux soient appliqués afin que l'énergie d'irradiation dirigée coupe une direction d'écoulement du gaz s'écoulant au travers de la surface de traitement et de telle sorte que le courant gazeux enlève les contaminants détachés ou libérés par l'énergie d'irradiation de la surface de traitement, caractérisé en ce que
b) un courant gazeux continu desdits moyens d'amenée d'un courant gazeux est placé en contact avec, et s'écoule sur une pluralité de surfaces de traitement d'un substrat qui sont orientées dans des plans non coïncidents, et
c) un rayonnement est dirigé vers ladite pluralité de surfaces de traitement non coïncidentes afin de fournir une quantité essentiellement égale de rayonnement aux surfaces de traitement du substrat orientées dans des plans non coïncidents tandis que lesdits moyens pour conduire un courant gazeux appliquent un courant gazeux continu sur les surfaces de traitement du substrat irradié de telle sorte que l'énergie irradiée et le courant gazeux se coupent et soient appliqués de manière coordonnée pour enlever et emporter les contaminants déposés dessus sans modifier la structure cristalline moléculaire des surfaces du substrat malgré leur présence dans des plans non coïncidents.

30. Méthode selon la revendication 29 dans laquelle l'irradiation et l'amenée d'un courant gazeux comprennent l'irradiation et l'amenée d'un courant gazeux avec un ensemble combiné de conduites de rayonnement et de gaz (53) ayant une extrémité d'entrée et une extrémité de sortie et ladite irradiation comprend l'insertion de l'extrémité de sortie dudit ensemble de conduites de rayonnement et de gaz dans une enceinte allongée (70) et la déviation du rayonnement radialement vers l'extérieur de l'axe central dudit ensemble de conduites de rayonnement et de gaz sur les surfaces de traitement non coïncidentes du substrat définies par l'enceinte allongée, et l'amenée dudit courant gazeux comprend l'amenée du courant gazeux radialement vers l'extérieur de l'axe central dudit ensemble de conduites de rayonnement et de gaz sur les surfaces de traitement non coïncidentes irradiées.

31. Méthode selon la revendication 29, dans laquelle les surfaces de traitement non coïncidentes sont définies par un intérieur d'un tuyau cylindrique allongé (70) et délivrant un courant gazeux comprenant l'amenée d'un courant gazeux hors de la conduite de gaz avec une ouverture adjacente à une sortie (54) pour une conduite de rayonnement desdits moyens d'irradiation et ladite ouverture de la conduite de gaz étant positionnée par rapport à la sortie de la conduite de rayonnement à la suite de quoi ledit courant gazeux entre en contact avec les surfaces de traitement non coïncidentes en amont d'une position de contact pour le rayonnement dirigé vers l'extérieur de ladite conduite de rayonnement de manière à ce que le courant gazeux soit à nouveau dirigé dans une direction d'écoulement qui s'étend sur une enceinte allongée, laquelle direction d'écoulement coupe le rayonnement dirigé vers l'extérieur de ladite conduite de rayonnement.

32. Méthode selon la revendication 29, dans laquelle l'application d'un courant gazeux continu sur les surfaces de traitement non coïncidentes comprend l'ajustage en position d'une source dudit courant gazeux continu afin d'ajuster le courant gazeux continu conformément aux changements d'orientation des surfaces de traitement non coïncidentes.

33. Méthode selon la revendication 29, dans laquelle lesdits moyens pour diriger un courant gazeux comprennent une conduite principale de courant gazeux qui est ajustable en position et une source secondaire de courant gazeux qui fournit un courant continu régulier non ajusté d'un courant gazeux (55') devant le substrat tandis que la conduite principale de courant gazeux dirige un courant gazeux primaire vers le substrat.

34. Appareil selon la revendication 5 comprenant en outre une enceinte (15) pour enfermer le substrat traité et une source secondaire de courant gazeux qui est utilisée conjointement avec le courant gazeux fourni par ladite conduite de courant gazeux.

35. Appareil selon la revendication 1 comprenant en outre un support (84) pour le substrat traité (70), et lesdits moyens pour irradier (53) et lesdits moyens pour conduire un courant gazeux ajustable (53) pour irradier et appliquer un courant gazeux sur chacune des surfaces non coïncidentes traitées tandis que le substrat est fixé dans une position unique pendant le traitement des surfaces de traitement non coïncidentes.
